(19) Europäisches Patentamt
European Patent Office
Office européen des brevets

(11) **EP 3 597 790 A1**

(12) **EUROPEAN PATENT APPLICATION**

(43) Date of publication:
**22.01.2020  Bulletin 2020/04**

(51) Int Cl.:
***C23C 16/458*** (2006.01)          ***C23C 16/46*** (2006.01)
***C30B 25/12*** (2006.01)           ***H05B 6/10*** (2006.01)

(21) Application number: **19187450.2**

(22) Date of filing: **19.07.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **19.07.2018   US 201862700690 P**

(71) Applicants:
• **King Abdullah University Of Science And Technology**
  **Thuwal 23955 (SA)**

• **King Fahd University of Petroleum and Minerals Dhahran 34464 (SA)**

(72) Inventors:
• **LI, Xiaohang**
  **23955 Thuwal (SA)**
• **LI, Kuang-Hui**
  **23955 Thuwal (SA)**
• **ALOTAIBI, Hamad Saud**
  **34464 DHAHRAN (SA)**

(74) Representative: **Tessier, Benoit Sebastien et al Ipsilon**
  **Le Centralis**
  **63, avenue du Général Leclerc**
  **92340 Bourg-la-Reine (FR)**

(54) **SUSCEPTORS FOR INDUCTION HEATING WITH THERMAL UNIFORMITY**

(57)  Embodiments of the present disclosure describe a susceptor for chemical vapor deposition comprising a horizontal component with a top surface and a bottom surface, wherein the top surface is configured to support one or more wafers; a vertical component extending from the bottom surface of the horizontal component along a longitudinal axis that is substantially perpendicular to the horizontal component; and a hollow region within the vertical component. Embodiments of the present disclosure describe a susceptor for chemical vapor deposition comprising a horizontal plate with a top surface configured to support one or more wafers, a vertical rod integrated with and perpendicular to the horizontal plate, and a hollow region within the vertical rod for promoting temperature uniformity across the top surface of the horizontal plate.

*FIG. 1*

**Description**

**BACKGROUND**

A conventional cylinder-shaped solid susceptor with a hole in the bottom thereof is commonly used in chemical vapor deposition systems with induction heating. However, the conventional hole design does not take into account properties of induction heating and heat transfer. As a result, the susceptor surface temperature is not uniform. For instance, at the center of the susceptor surface, the temperature can be considerably higher (or lower) than the temperature at the edge. This non-uniform temperature distribution across the surface of the susceptor surface is undesirable for the uniformity of physical and chemical properties of the deposited materials. Such non-uniform temperature distributions are also undesirable where control over growth temperature is critical for material fabrication and growth.

**SUMMARY**

In general, embodiments of the present disclosure describe susceptors for induction heating with thermal uniformity.
Accordingly, embodiments of the present disclosure describe a susceptor for chemical vapor deposition comprising a horizontal component with a top surface and a bottom surface, wherein the top surface is configured to support one or more wafers; a vertical component extending from the bottom surface of the horizontal component along a longitudinal axis that is substantially perpendicular to the horizontal component; and a hollow region within the vertical component.
Embodiments of the present disclosure further describe a susceptor for chemical vapor deposition comprising a horizontal plate with a top surface configured to support one or more wafers, a vertical rod integrated with and perpendicular to the horizontal plate, and a hollow region within the vertical rod for promoting temperature uniformity across the top surface of the horizontal plate.
The details of one or more examples are set forth in the description below. Other features, objects, and advantages will be apparent from the description and from the claims.

**BRIEF DESCRIPTION OF DRAWINGS**

This written disclosure describes illustrative embodiments that are non-limiting and non-exhaustive. In the drawings, which are not necessarily drawn to scale, like numerals describe substantially similar components throughout the several views. Like numerals having different letter suffixes represent different instances of substantially similar components. The drawings illustrate generally, by way of example, but not by way of limitation, various embodiments discussed in the present document.
Reference is made to illustrative embodiments that are depicted in the figures, in which:

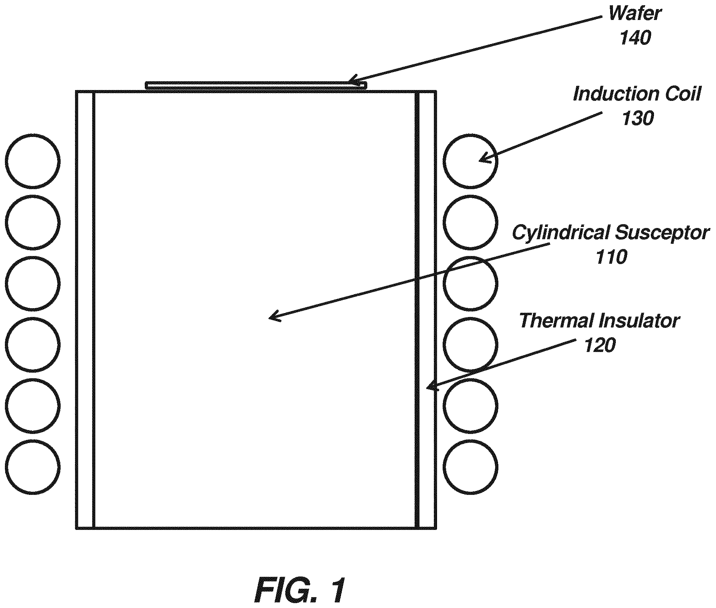

**FIG. 1** is a schematic diagram of a design of a solid cylinder-shaped susceptor surrounded by a thermal insulator with induction coils, according to one or more embodiments of the present disclosure.

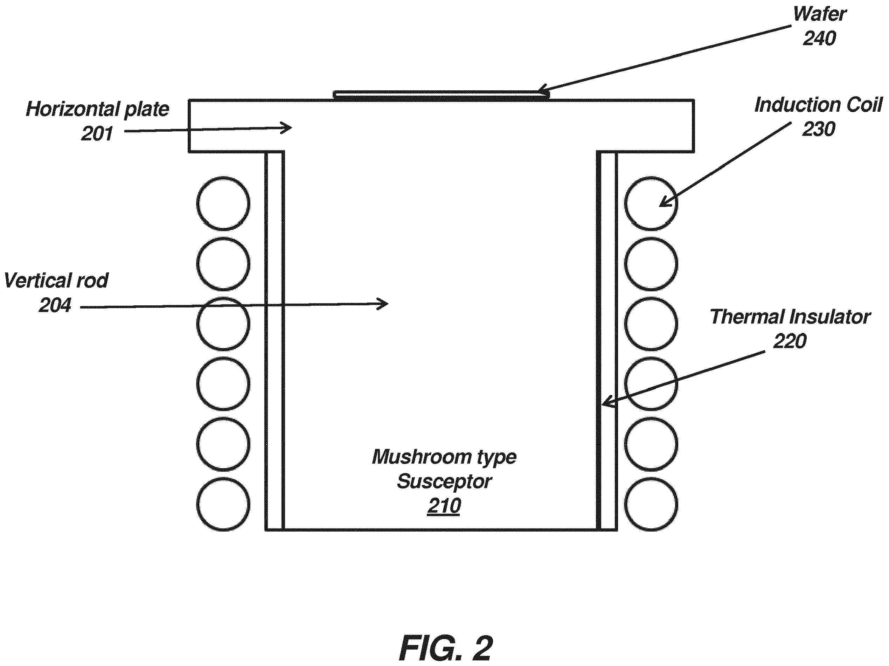

**FIG. 2** is a schematic diagram of a design of a solid mushroom-shaped susceptor surrounded by a thermal insulator with induction coils, according to one or more embodiments of the present disclosure.

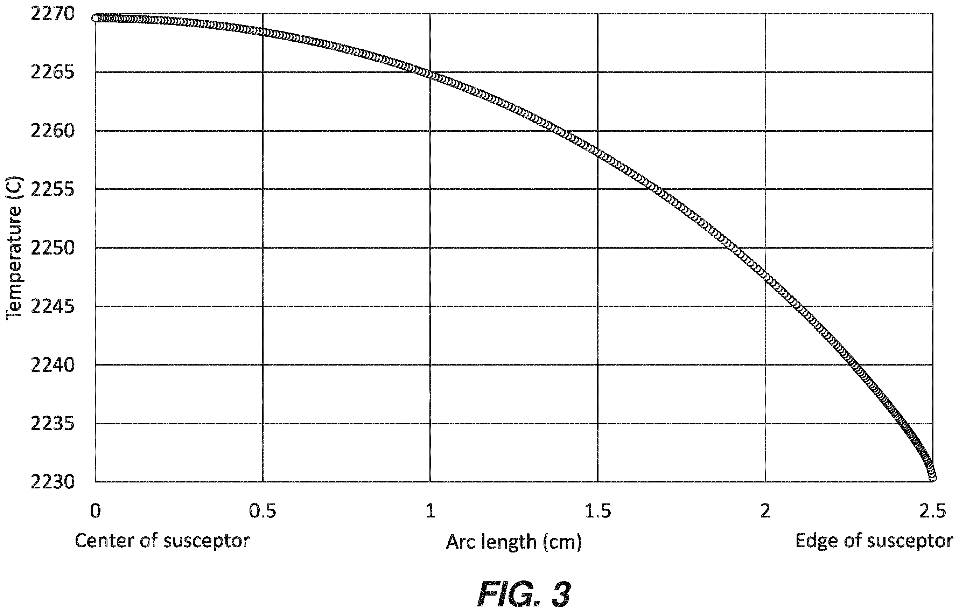

**FIG. 3** is a graphical view of a temperature profile showing temperature non-uniformity of a 2" wafer on the solid cylinder-shaped susceptor of **FIG. 1**, according to one or more embodiments of the present disclosure.

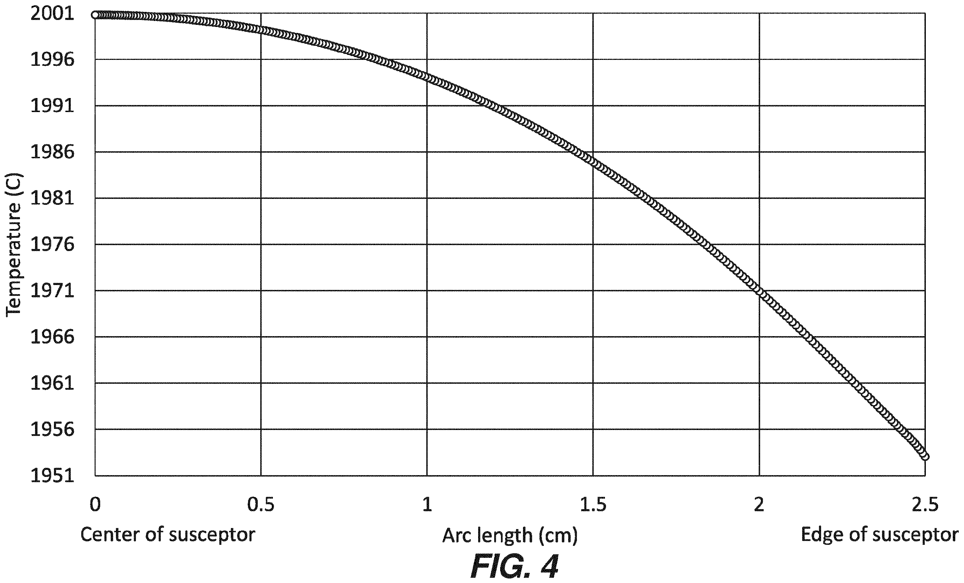

**FIG. 4** is a graphical view of a temperature profile showing temperature non-uniformity of a 2" wafer on the solid mushroom-shaped susceptor of **FIG. 2**, according to one or more embodiments of the present disclosure.

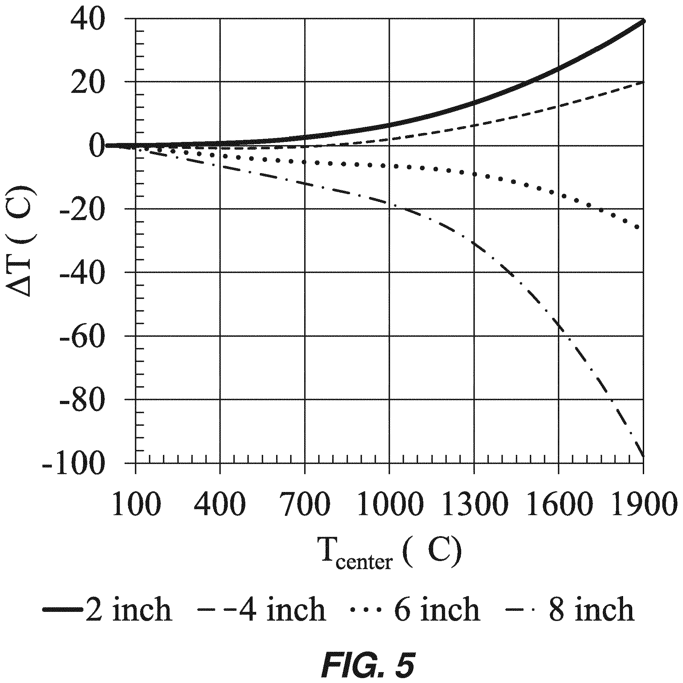

**FIG. 5** is a graphical view of temperature profiles for 2, 4, 6, and 8 inch wafers, wherein the temperature profiles show temperature non-uniformity and a large increase in the temperature difference between the center and edge of the wafer as the temperature increases beyond 1000 °C, according to one or more embodiments of the present disclosure.

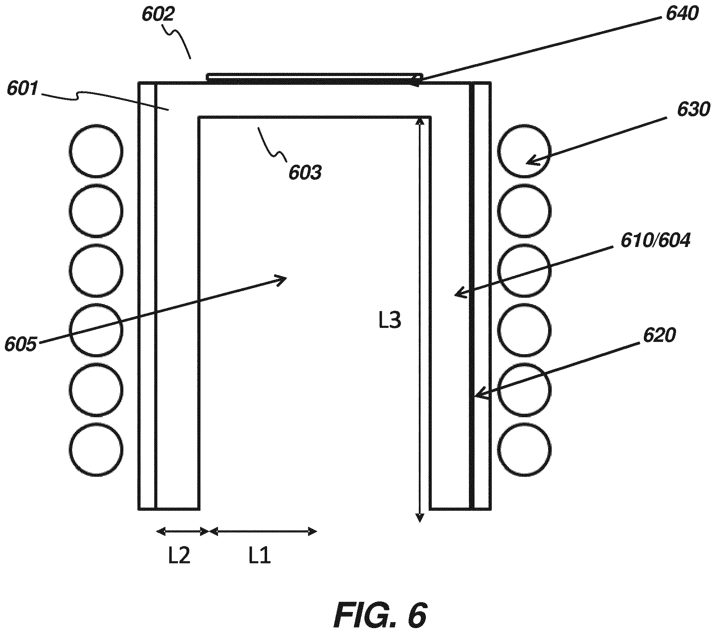

**FIG. 6** is a schematic diagram of a hollowed cylinder-shaped susceptor with enhanced thermal uniformity on the top surface with the radius and depth of the cylindrical hollow region dependent upon the material, frequency, and temperature, according to one or more embodiments of the present disclosure.

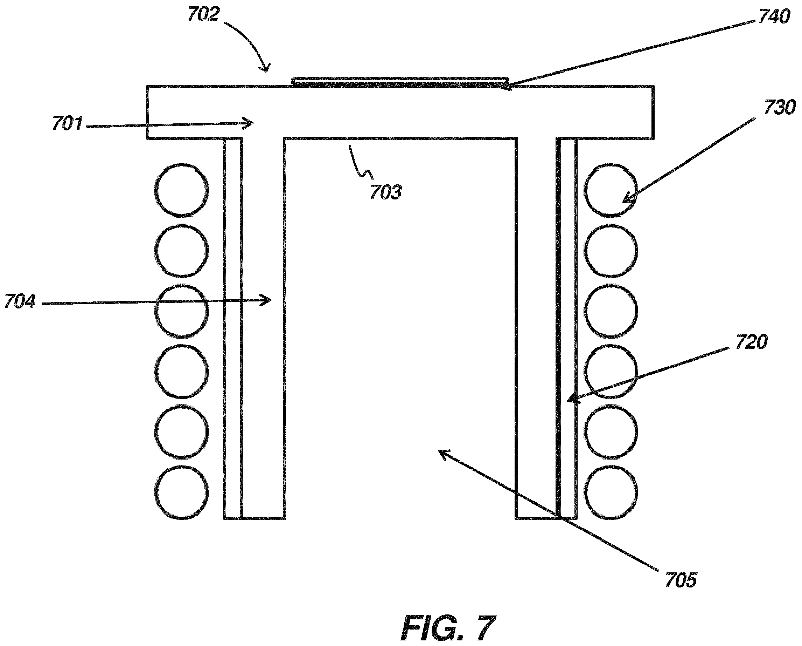

**FIG. 7** is a schematic diagram of a hollowed mushroom-shaped susceptor with enhanced thermal uniformity on the top surface with the radius and depth of the cylindrical hollow region dependent upon the material frequency, and temperature, according to one or more embodiments of the present disclosure.

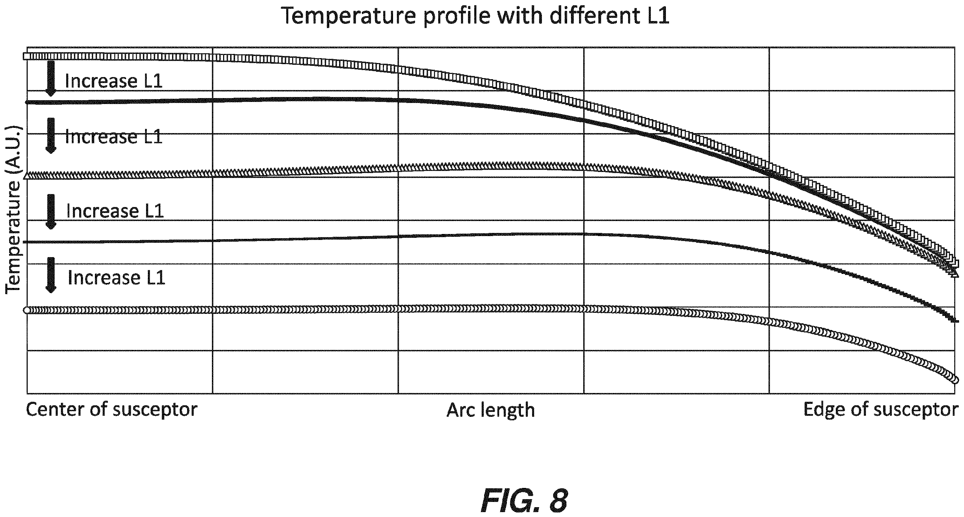

**FIG. 8** is a graphical view of a temperature profile showing an improvement in temperature uniformity with an increase in L1, according to one or more embodiments of the present disclosure.

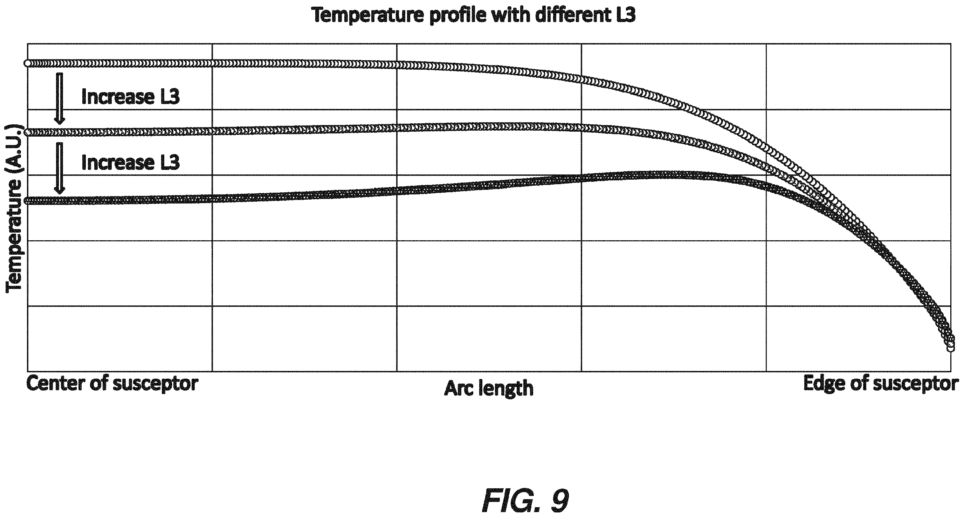

**FIG. 9** is a graphical view of a temperature profile showing an improvement in temperature uniformity with an increase in L3, according to one or more embodiments of the present disclosure.

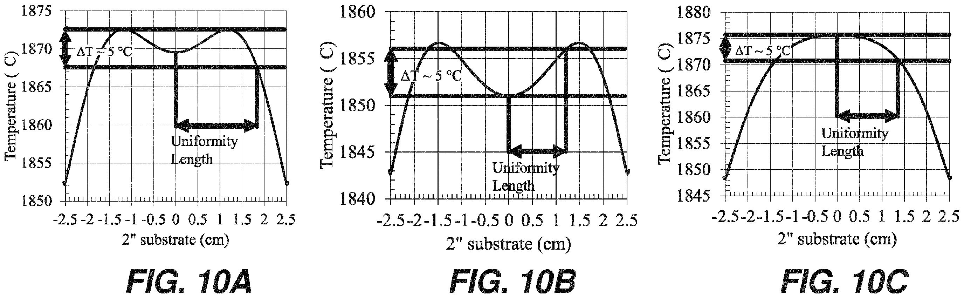

**FIGS. 10A-10C** are graphical views showing various definitions of uniformity length of a 2" substrate, according to one or more embodiments of the present disclosure.

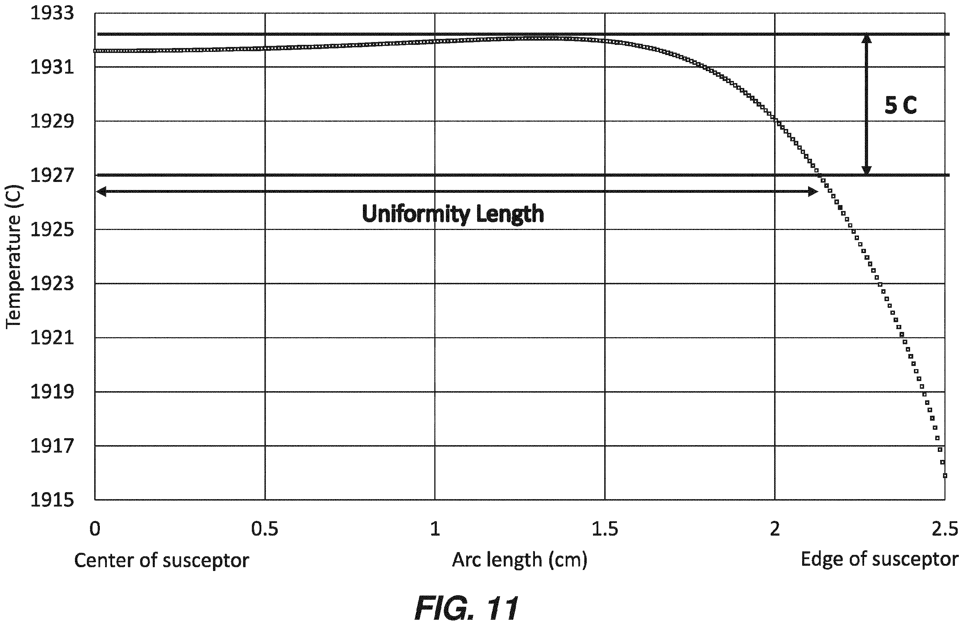

**FIG. 11** is a graphical view showing how to define uniformity length on a 2" wafer, according to one or more embodiments of the present disclosure.

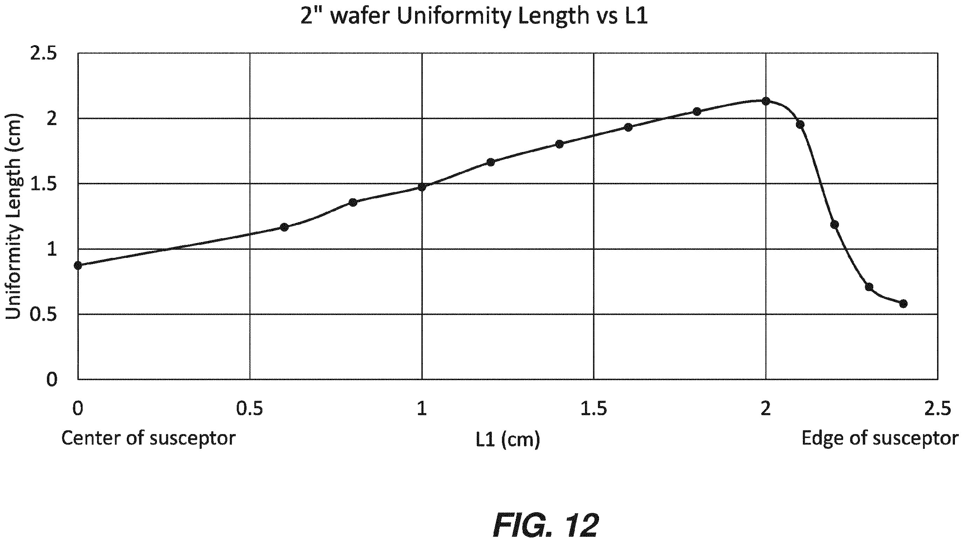

**FIG. 12** is a graphical view showing how uniformity length of a 2" wafer varies with increasing L1, according to one or more embodiments of the present disclosure.

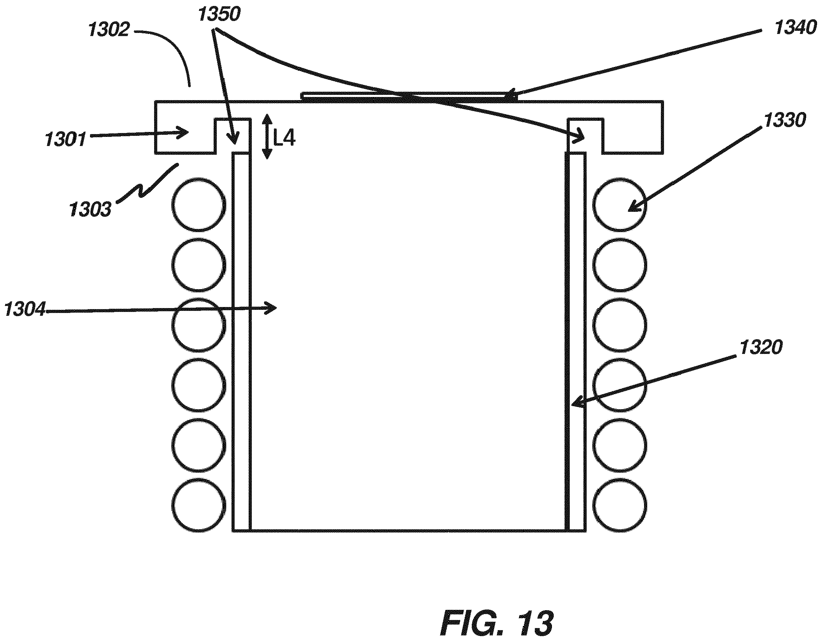

**FIG. 13** is a schematic diagram of a mushroom-like susceptor with a groove structure beneath the horizontal plate for blocking heat transfer to the end, according to one or more embodiments of the present disclosure.

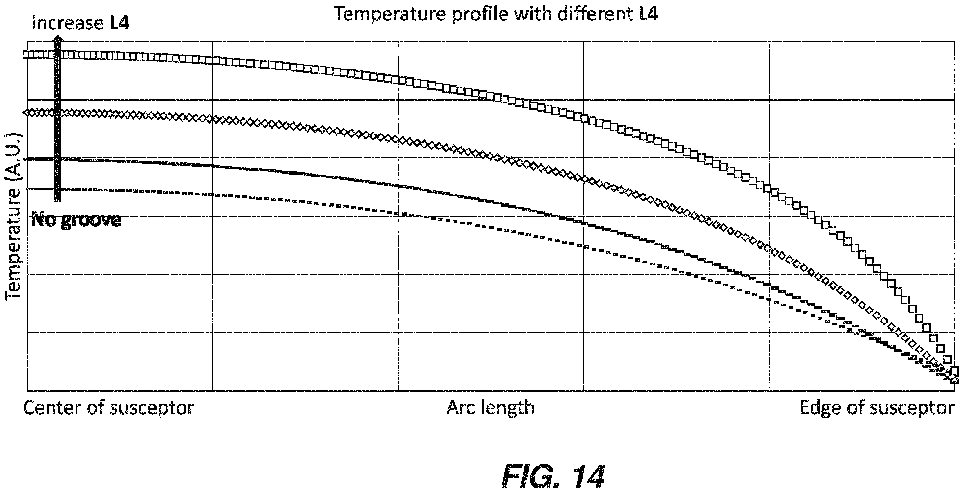

**FIG. 14** is a graphical view of a temperature profile showing a rise in surface temperature with an increase in L5 which blocks heat transfer to the edge of the horizontal plate, according to one or more embodiments of the present disclosure.

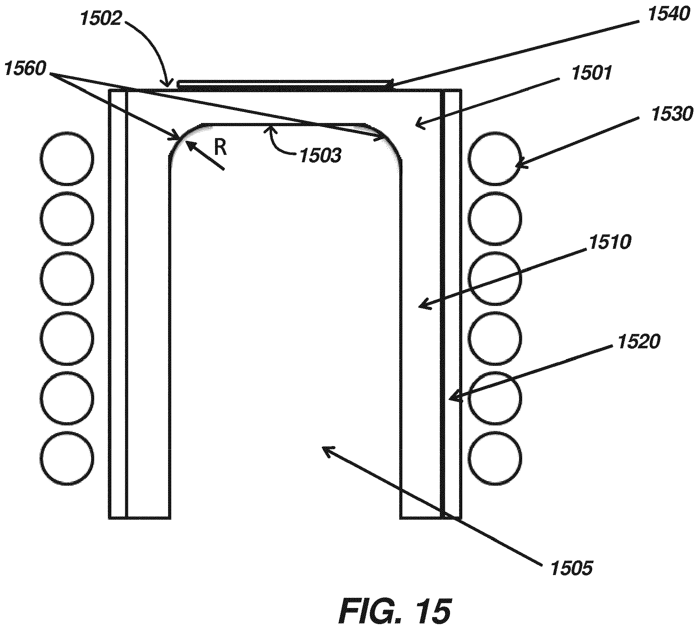

**FIG. 15** is a schematic diagram of a hollowed cylinder-shaped susceptor with enhanced thermal uniformity on the top surface with a fillet structure in a corner of the hollow region for enhanced heat transfer, according to one or more embodiments of the present disclosure.

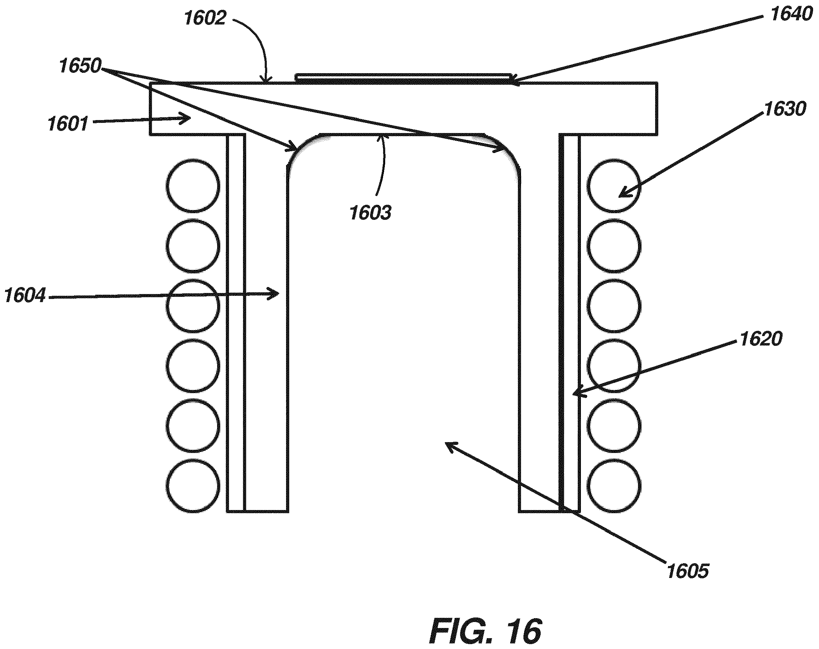

**FIG. 16** is a schematic diagram of a hollowed mushroom-shaped susceptor with enhanced thermal uniformity on the top surface with a fillet structure in a corner of the hollow region for enhanced heat transfer, according to one or more embodiments of the present disclosure.

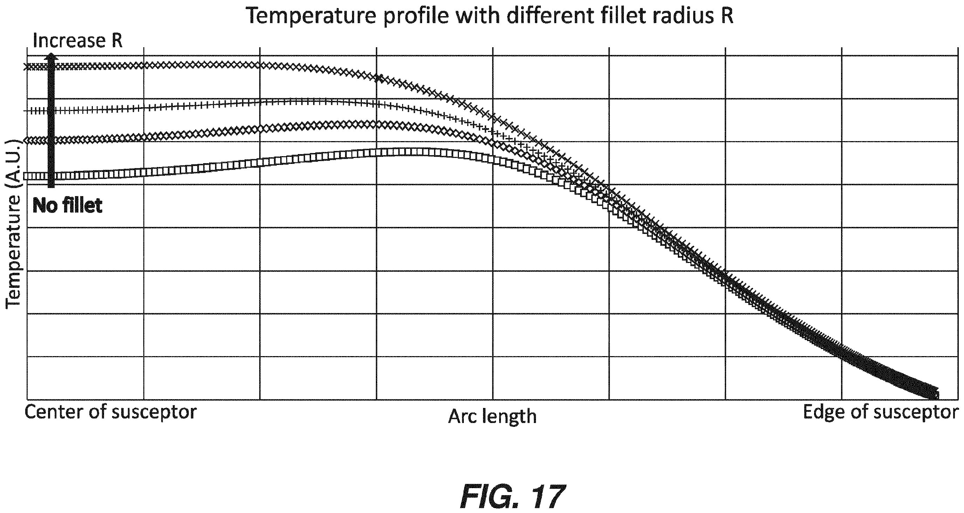

**FIG. 17** is a graphical view of a temperature profile showing an improvement in heat transfer with an increase in R, according to one or more embodiments of the present disclosure.

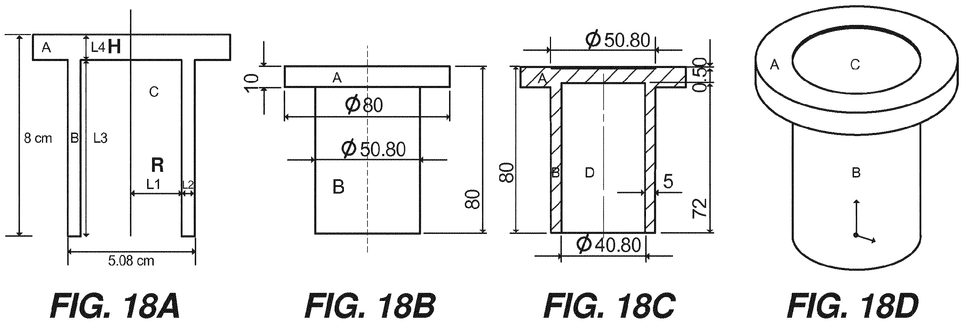

**FIGS. 18A-18D** are schematic diagrams of a mushroom-type susceptor showing (A)-(C) various cross-sectional views of a mushroom susceptor and (D) an isometric view of a mushroom-type susceptor, according to one or more embodiments of the present disclosure.

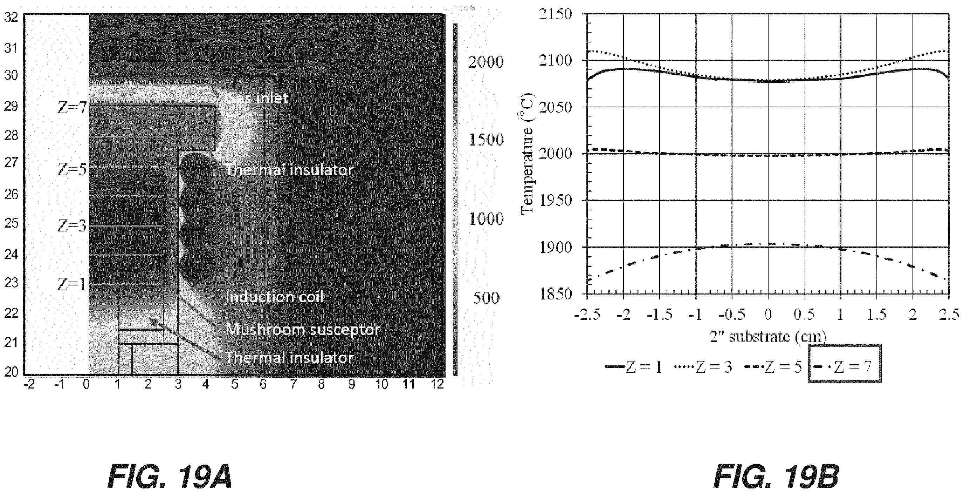

**FIGS. 19A-19B** show (A) a schematic diagram of a mushroom-type susceptor for a 2 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure.

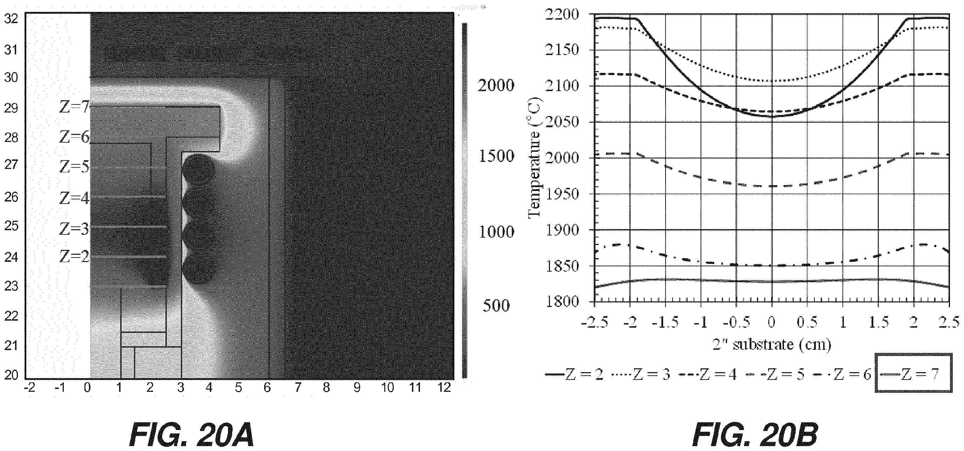

**FIGS. 20A-20B** show (A) a schematic diagram of a mushroom-type susceptor for a 2 inch substrate with a hollow region, where Z = 2 to 7 identify positions that correspond to cross-section temperature profiles shown in (B), and (B) is a graphical view of the cross-section temperature profiles of the susceptor at corresponding positions Z = 2 to 7, according to one or more embodiments of the present disclosure.

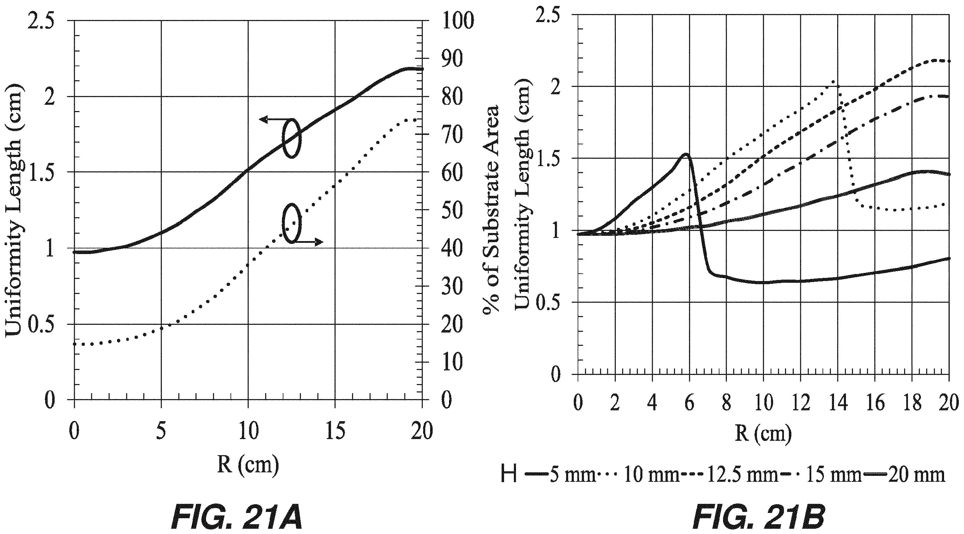

**FIGS. 21A-21B** show, for a susceptor for a 2 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure.

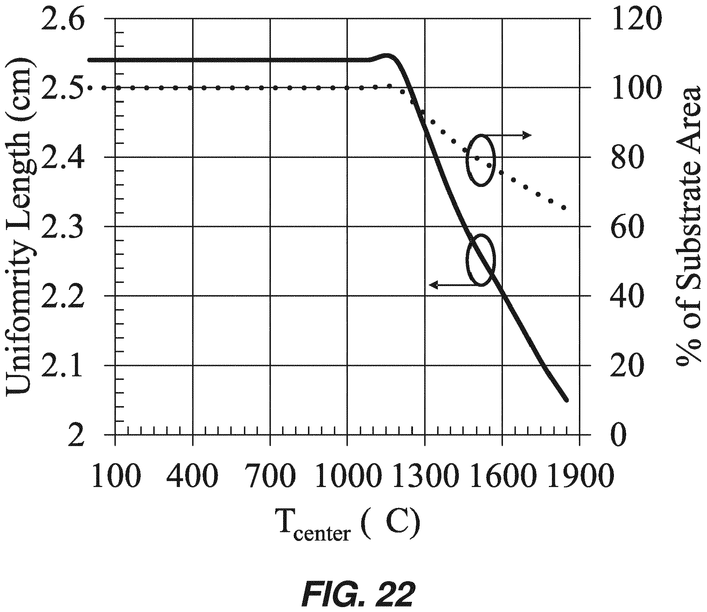

**FIG. 22** is a graphical view of uniformity length (left y-axis) and percent of substrate area with temperature non-uniformity less than 5 °C (right y-axis) versus temperature, according to one or more embodiments of the present disclosure.

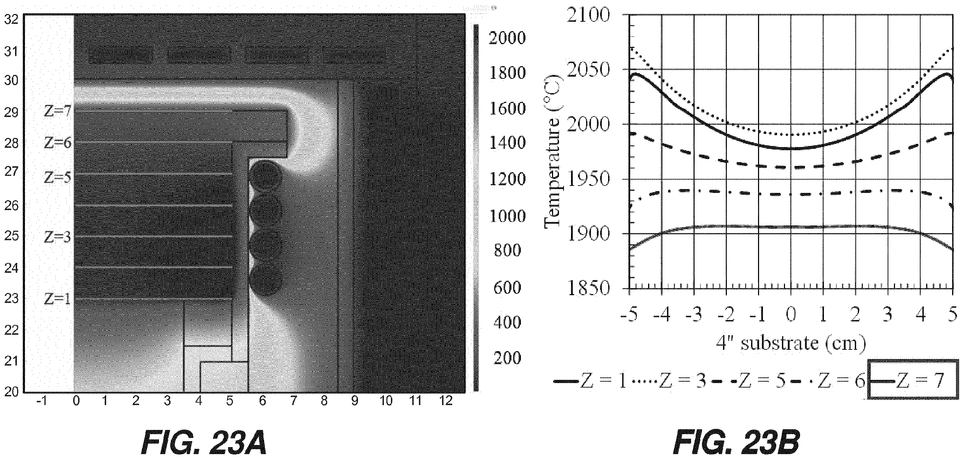

**FIGS. 23A-23B** show (A) a schematic diagram of a mushroom-type susceptor for a 4 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure.

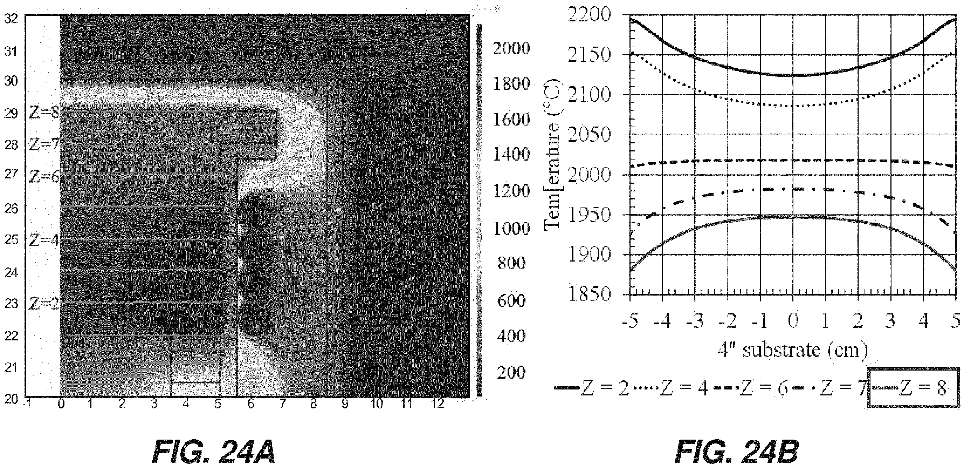

**FIGS. 24A-24B** show (A) a schematic diagram of a mushroom-type susceptor for a 4 inch substrate with the induction coils shifted downward, where Z = 2 to 8 identify positions that correspond to cross-section temperature profiles shown in (B), and (B) is a graphical view of the cross-section temperature profiles of the susceptor at corresponding positions Z = 2 to 8, according to one or more embodiments of the present disclosure.

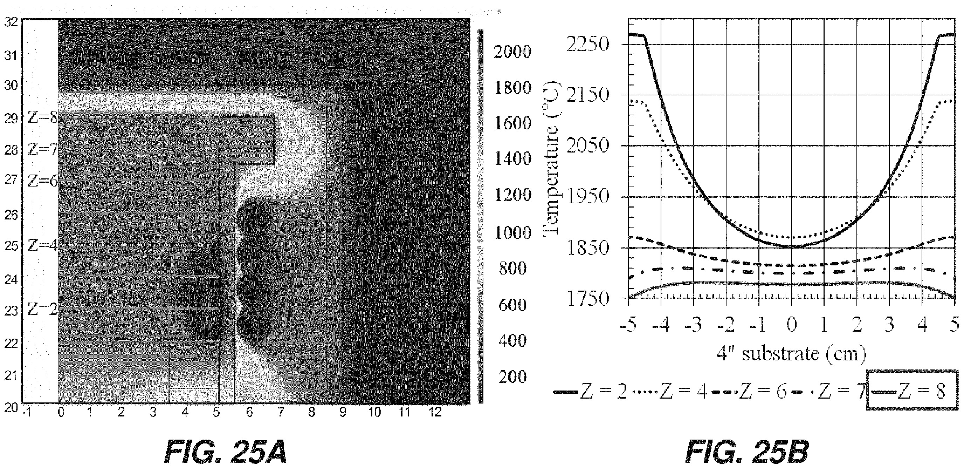

**FIGS. 25A-25B** show (A) a schematic diagram of a mushroom-type susceptor for a 4 inch substrate with a hollow region and the induction coils shifted downward, where Z = 2 to 8 identify positions that correspond to cross-section temperature profiles shown in (B), and (B) is a graphical view of the cross-section temperature profiles of the susceptor at corresponding positions Z = 2 to 8, according to one or more embodiments of the present disclosure.

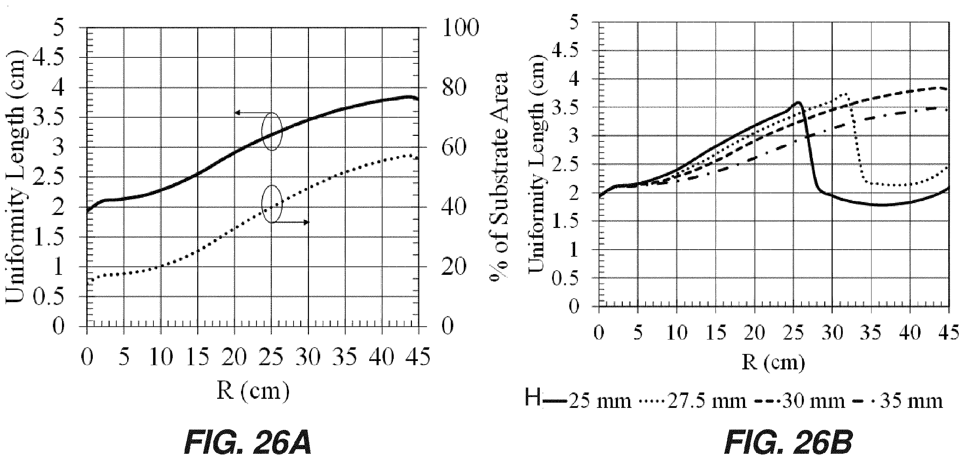

**FIGS. 26A-26B** show, for a susceptor for a 4 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various H (thicknesses of the horizontal component), according to one or more embodiments of the present disclosure.

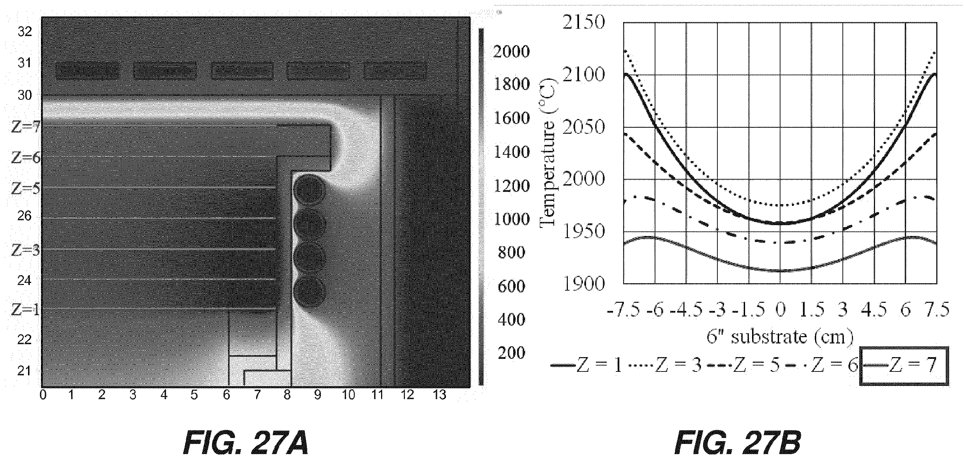

**FIGS. 27A-27B** show (A) a schematic diagram of a mushroom-type susceptor for a 6 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure.

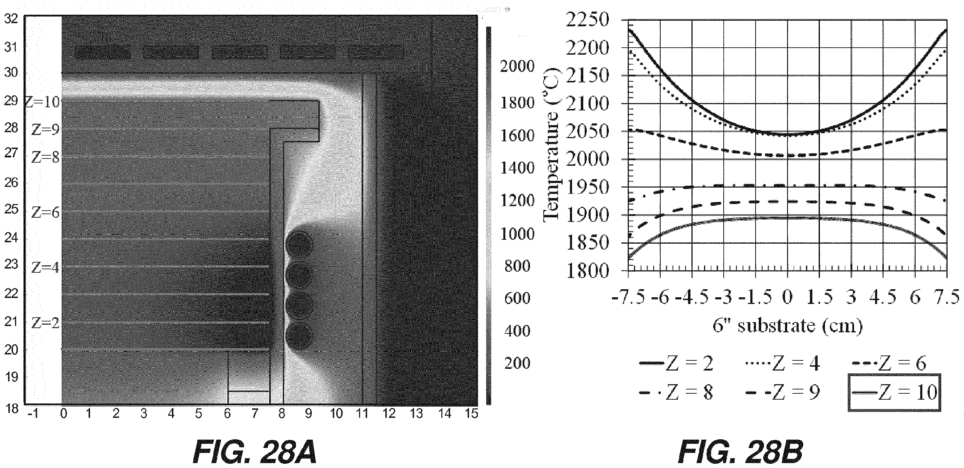

**FIGS. 28A-28B** show (A) a schematic diagram of a mushroom-type susceptor for a 6 inch substrate with the induction coils shifted downward, where Z = 2 to 10 identify positions that correspond to cross-section temperature profiles shown in (B), and (B) is a graphical view of the cross-section temperature profiles of the susceptor at corresponding positions Z = 2 to 10, according to one or more embodiments of the present disclosure.

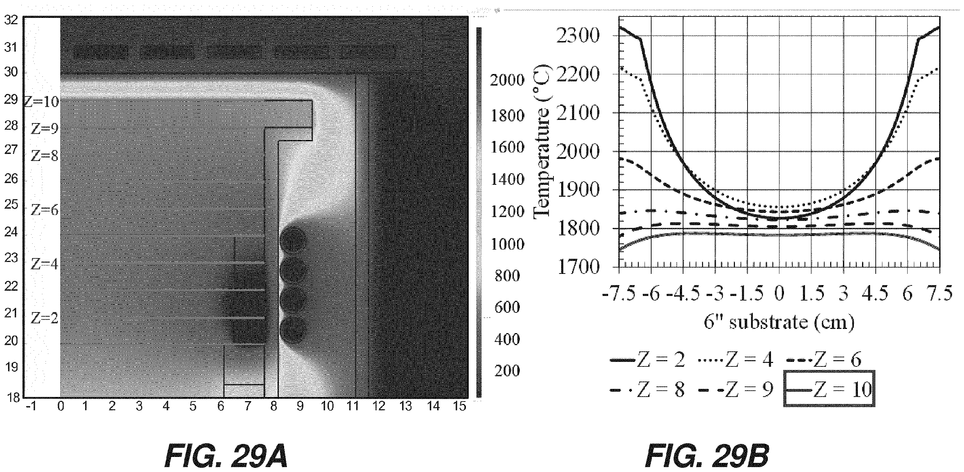

**FIGS. 29A-29B** show (A) a schematic diagram of a mushroom-type susceptor for a 6 inch substrate with a hollow region and the induction coils shifted downward, where Z = 2 to 10 identify positions that correspond to cross-section temperature profiles shown in (B), and (B) is a graphical view of the cross-section temperature profiles of the susceptor at corresponding positions Z = 2 to 10, according to one or more embodiments of the present disclosure.

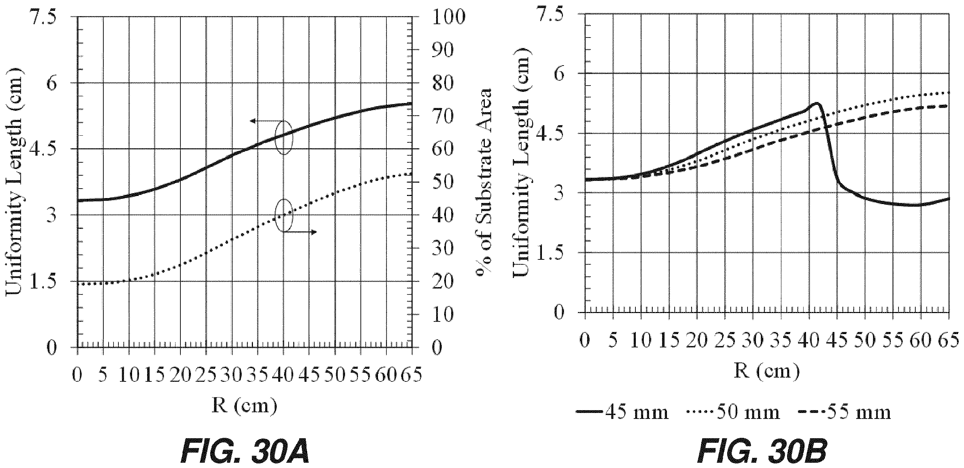

**FIGS. 30A-30B** show, for a susceptor for a 6 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure.

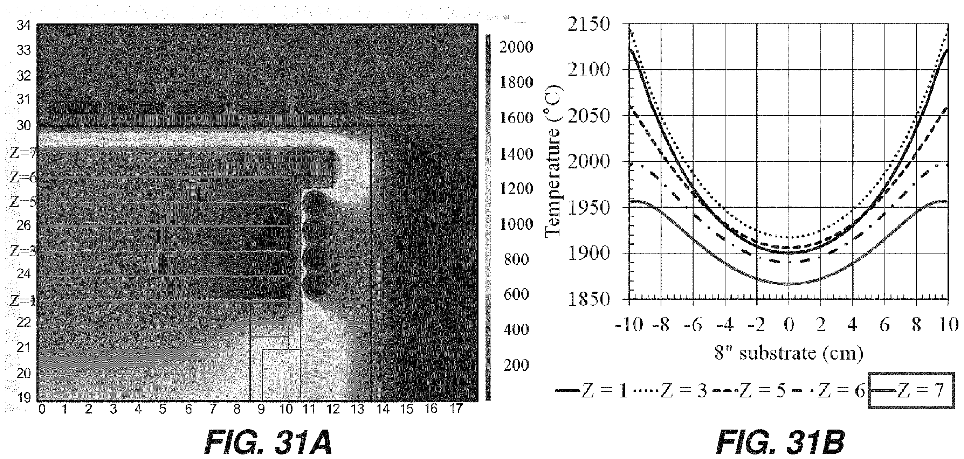

**FIGS. 31A-31B** show (A) a schematic diagram of a mushroom-type susceptor for a 8 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure.

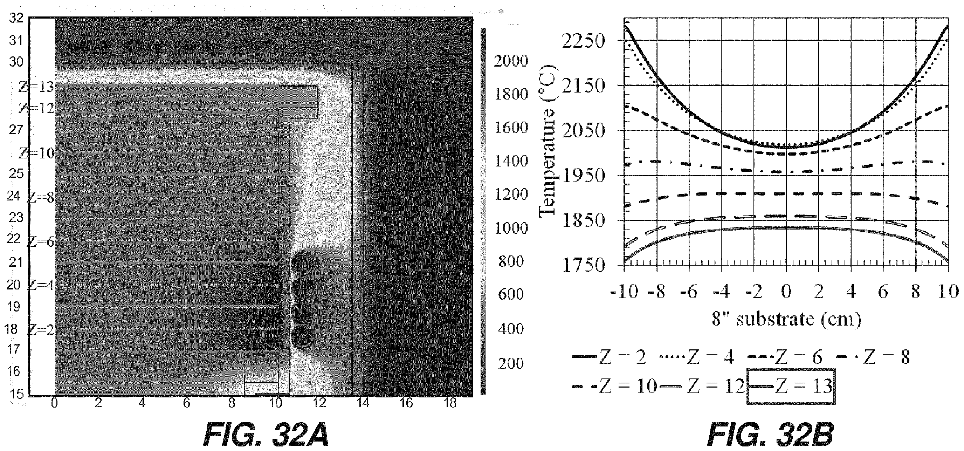

**FIGS. 32A-32B** show (A) a schematic diagram of a mushroom-type susceptor for a 8 inch substrate with the induction coils shifted downward, where Z = 2 to 13 identify positions that correspond to cross-section temperature profiles shown in (B), and (B) is a graphical view of the cross-section temperature profiles of the susceptor at corresponding positions Z = 2 to 13, according to one or more embodiments of the present disclosure.

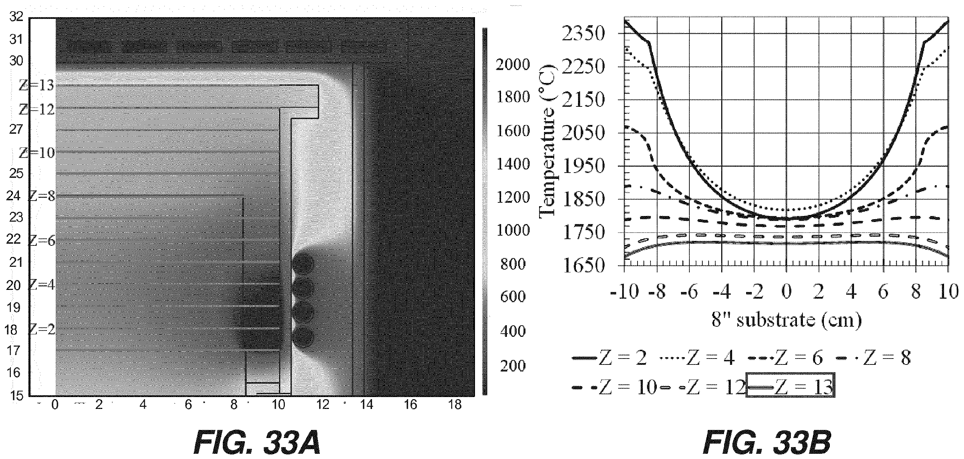

**FIGS. 33A-33B** show (A) a schematic diagram of a mushroom-type susceptor for a 8 inch substrate with a hollow region and the induction coils shifted downward, where Z = 2 to 13 identify positions that correspond to cross-section temperature profiles shown in (B), and (B) is a graphical view of the cross-section temperature profiles of the susceptor at corresponding positions Z = 2 to 13, according to one or more embodiments of the present disclosure.

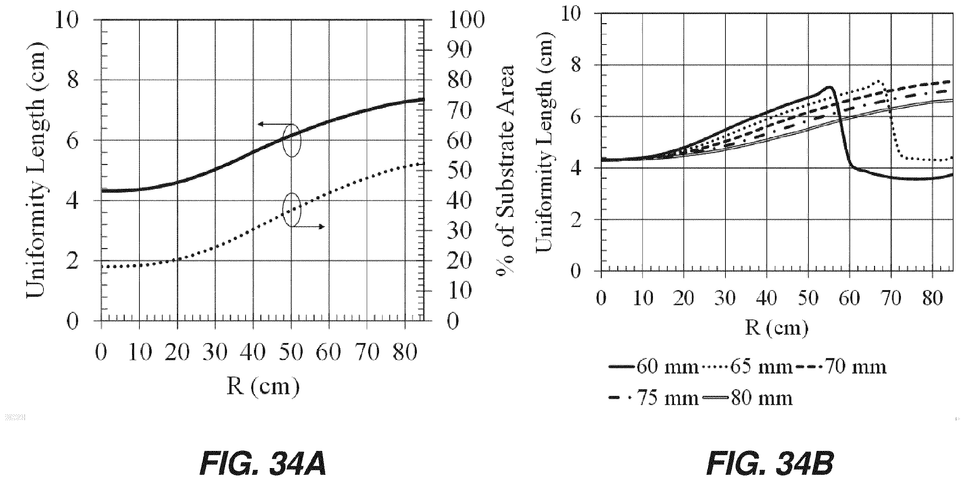

**FIGS. 34A-34B** show, for a susceptor for a 8 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure.

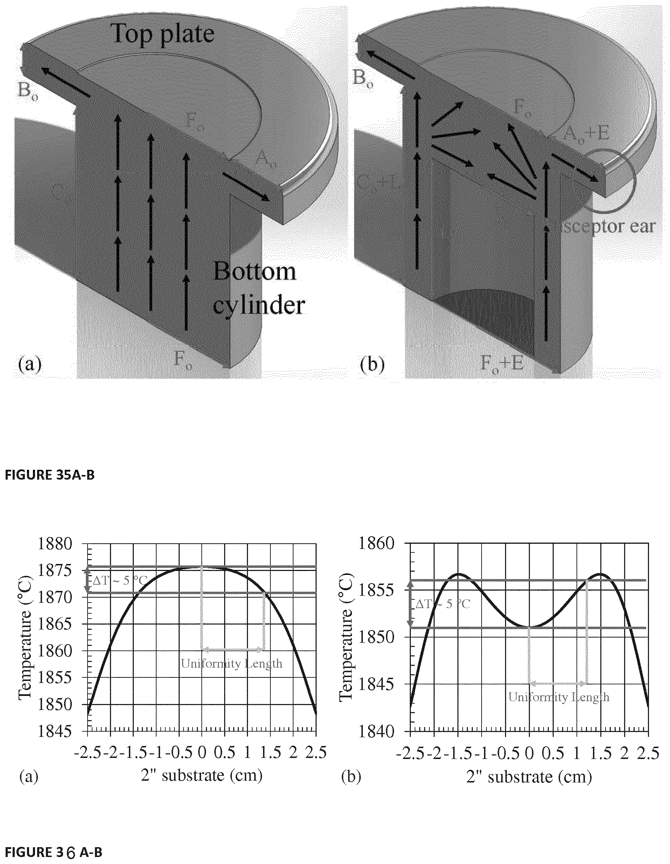

**FIGS. 35A-B, 36A-B, 37A-B, 38, 39A-D, 40A-F, 41A-B** are supplementary to Example 3.

## DETAILED DESCRIPTION

The invention of the present disclosure relates to susceptors for chemical vapor deposition (CVD) and/or metal-organic chemical vapor deposition (MOCVD). It is based on the devices, apparatuses, and methods described more fully in U.S. Patent Application No. 62396679, which is incorporated by reference in its entirety. The susceptors of the present disclosure provide a uniform and/or substantially uniform temperature distribution for the fabrication of high-quality thin films. In particular, the invention of the present disclosure relates to susceptors with hollow regions for providing a uniform and/or substantially uniform temperature distribution across a top surface of the susceptor. The susceptors of the present disclosure may, for example, include a horizontal component (e.g., horizontal plate) with a top surface and a bottom surface, wherein the top surface is configured to support one or more wafers; a vertical component (e.g., vertical rod) extending from the bottom surface of the horizontal component along a longitudinal axis that is substantially perpendicular to the horizontal component; and a hollow region within the vertical component. The hollow region may be within the vertical rod and characterized by a depth and/or radius that may be adjusted to meet the requirements of a particular application. Other dimensions and parameters of the susceptor also may be adjusted to meet application requirements.

**FIGS. 1** and **2** are schematic diagrams of a design of a solid susceptor surrounded by a thermal insulator with induction coils, according to one or more embodiments of the present disclosure. In particular, **FIG. 1** is a schematic diagram of a design of a solid cylindrical-shaped susceptor 110 with thermal insulator 120. Induction coils 130 are provided to an exterior of the thermal insulator 120 and surround both the thermal insulator 120 and the cylindrical-shaped susceptor 110. A wafer 140 is provided on a surface of the cylindrical susceptor. **FIG. 2** is a schematic diagram of a design of a solid mushroom-shaped susceptor 210. The mushroom-shaped susceptor includes a horizontal plate 201 positioned above a vertical rod 204. A thermal insulator 220 surrounds the vertical rod 204 and an induction coil 230 surrounds both the thermal insulator 220 and the vertical rod 204.

A difference between the susceptors of **FIGS. 1** and **2** is that the susceptor of **FIG. 1** is a solid cylinder-shaped susceptor and the susceptor of **FIG. 2** is a solid mushroom-shaped susceptor. In many embodiments, heat induction is used for MOCVD. For example, a power supply is utilized to pass an alternating current through the induction coils. The induction coils generate an alternating magnetic flux that penetrates the solid susceptor and induces eddy currents that flow through the susceptor according to Faraday's law and generate heat. The skin effect, however, limits the depth to which the eddy currents flow through the susceptor generally to a region between the surface of the susceptor and a level below the surface referred to as the skin depth. Eddy current thus does not flow along the radial direction of the susceptor uniformly. Heat transfer from that region may cause the temperature to be greater at the center of the susceptor than at the edges thereof due to the skin effect and geometry-dependent heat transfer. This results in a non-uniform temperature distribution in a radial direction of the susceptor.

**FIGS. 3** and **4** are graphical views of temperature profiles showing temperature non-uniformity of a 2" wafer on a solid cylinder-shaped susceptor and solid mushroom-shaped susceptor, respectively, according to one or more embodiments of the present disclosure. As shown in **FIG. 3**, the temperature difference between a center of the susceptor and an edge of the susceptor is about 40°C. As shown in **FIG. 4**, the temperature difference between a center of the susceptor and an edge of the susceptor is about 50°C.

In addition, a rise in temperature can also create larger temperature differences across a wafer. See, for example, **FIG. 5**, which is a graphical view of temperature profiles for 2, 4, 6, and 8 inch wafers, wherein the temperature profiles show temperature non-uniformity and a large increase in the temperature difference between the center and edge of the wafer as the temperature increases beyond 1000 °C, according to one or more embodiments of the present disclosure. As shown in **FIG. 5**, temperature difference between the center and edge of wafer may be large when the temperature is above 1000°C. For example, 2, 4, 6, and 8 inch wafers show temperature non-uniformity and the temperature difference increases as the temperature is raised.

Further, while a temperature difference of about 3 percent between the center and edge of the susceptor may be acceptable for growth temperatures between about 1000°C and about 1300°C, temperature uniformity may be critical for growth temperatures about 1700°C and above, as crystal quality of the entire wafer in MOCVD may be highly affected (e.g., lead to the formation of cracks and/or defects) by temperature non-uniformity and/or large variations in temperature across the surface of the susceptor and wafer. A susceptor design that provides a uniform and/or substantially uniform temperature distribution across a surface of the susceptor is thus desirable for the fabrication of high-quality thin films via MOCVD.

Embodiments of the present disclosure describe a susceptor for chemical vapor deposition. The susceptor may include a horizontal component (e.g., horizontal plate) with a top surface and a bottom surface, wherein the top surface is configured to support one or more wafers. A vertical component may extend from the bottom surface of the horizontal component along a longitudinal axis that is substantially perpendicular to the horizontal component. For example, the vertical component (e.g., vertical rod) may be integrated with and perpendicular to the horizontal plate. A hollow region may be within the vertical component. In some embodiments, the susceptor or hollow region may further comprise fillets. In some embodiments, the susceptor or horizontal component may further comprise grooves or groove structures. In some embodiments, the susceptor further comprises one or more of a thermal insulator and induction coils (e.g., for generating heat). In some embodiments, the induction coil may be shifted downwards (e.g., by about 10 mm, or greater or less than 10 mm depending on the design) from the horizontal component. In some embodiments, the susceptor is a mushroom-shaped susceptor, a cylinder-shaped susceptor, or any other shaped susceptor suitable for the application.

The horizontal component (e.g., horizontal plate) may include a top surface and a bottom surface. The horizontal plate and the vertical rod may be made out of electronically or electrically conductive materials - and in many embodiments, not ionically conductive materials - as known in the art, including graphite, or refractory metals (e.g., molybdenum). The electronic conductivity must be sufficient to allow eddy current to be induced in the susceptor and for the temperature to rise via induction heating.

The horizontal plate may be configured to support one or more wafers. In some embodiments, the horizontal plate is configured with one or more impressions or depressions such that the one or more wafers may be secured (e.g., prevented from moving) on the horizontal plate. The number of wafers supported and/or secured by the horizontal plate may include at least one, at least two, or at least five, or 2-100. A typical size of the wafer may be about 2, 4, 6, 8, or 12 inches in diameter. Wafers are known in the art and can come from different sizes, such as, for example, 2, 3, 4, 6, or 8 inch wafers.

In some embodiments, the horizontal plate may be a cylindrical, symmetrical disk shape in which the diameter is larger than the height and the vertical rod may be a cylindrical, symmetrical disk shape in which the diameter is less than the height.

The vertical component (e.g., vertical rod) may extend form the bottom surface of the horizontal component along a longitudinal axis that is substantially perpendicular to the horizontal component. The vertical rod may be integrated with and perpendicular to the horizontal plate. Integrating the vertical rod with the horizontal plate may increase power efficiency, as the rod is occupying most of the magnetic flux zone, which means maximum power may be utilized to heat the vertical rod. In many embodiments, the vertical rod functions as a heat source for the horizontal plate. The ratio of plate diameter and vertical rod height may be related to the design and can be adapted for a particular application. The length of the vertical rod may be as long as the induction coil. The vertical rod may be surrounded by more turns of coils as the length of the vertical rod increases. The strength of the magnetic flux increases as the number of turns of coil increase. The stronger magnetic flux may induce more eddy current on the vertical rod and generate more heat. In some embodiments, the diameter of the vertical rod is equal to or larger than the wafer diameter.

In an embodiment, the horizontal component or horizontal plate may comprise a cylindrical symmetrical disk shape and the vertical component may comprise a cylindrical symmetrical disk shape. In an embodiment, the radius of the horizontal component is greater than the radius of the vertical component (e.g., mushroom-shaped). In an embodiment, the radius of the horizontal component is about equal to the radius of the vertical component. In an embodiment, the radius of the horizontal component is about equal to or less than the radius of the vertical component. In an embodiment, the horizontal component and the vertical component are made of the same material. In an embodiment, the horizontal component and the vertical component are made of different material. In an embodiment, the horizontal component and the vertical component form a single continuous structure. In an embodiment, the horizontal component and the vertical component are combined to form a structure comprised of separate components.

The ratio of the diameter of the horizontal plate to the length of the vertical rod can be, for example, about 1:0.8. The ratio between the diameter of the horizontal plate to the diameter of the rod may be important. If the diameter of the plate is much larger than the diameter of the rod, the plate periphery may not sufficiently increase in temperature. The ratio can be, for example, about 1:0.6.

The hollow region promotes temperature uniformity across the top surface of the horizontal plate. The hollow region reduces heat transfer to the center of the top surface of the susceptor to provide a more uniform (e.g., uniform and/or substantially uniform) temperature distribution. For example, while the center of the top surface of a solid susceptor increased in temperature due to heat transfer from the edge of the susceptor and from the region below it, the center of the top surface of a hollow susceptor increases in temperature substantially only due to heat transfer from the edge. Heat transfer from the region below the top surface is minimal (e.g., negligible). In this way, among others, the invention of the present disclosure provides a uniform and/or substantially uniform temperature distribution across the top surface suitable for fabricating high-quality films. In many embodiments, the hollow region within the vertical component may include a cylindrical shape. However, this shall not be limiting as the hollow region may comprise any shape suitable for and/or that promotes temperature uniformity.

An insulating layer or insulating material may surround the vertical rods. In many embodiments, the insulating layer may be utilized to confine heat inside the vertical rod and to conduct the maximum heat toward the horizontal plate. The insulating layer may also be utilized to protect the coils from excessive heat.

The temperature distributions in embodiments with hollowed susceptors are more uniform than the temperature distributions in embodiments in which solid cylinder-shaped susceptors and/or solid mushroom-shaped susceptors are utilized. At least one reason for this is that the center of the solid susceptor increases in temperature due to heat transfer from below the top surface and from the edges of the susceptor; however, with respect to hollow susceptors, the center of the top surface of the susceptor increases in temperature only from heat transfer from the edges, which makes the temperature more uniform across the top surface.

In an embodiment, the top surface of the horizontal component has a substantially uniform temperature distribution in the radial direction. In an embodiment, the temperature difference across the top surface of the horizontal component in the radial direction is less than or equal to about 3 percent. In an embodiment, the temperature difference across the top surface of the horizontal component in the radial direction is less than about 20 °C, less than about 15 °C, less than about 10 °C, less than about 5 °C, or less than about 1 °C. In a preferred embodiment, the temperature difference is less than about 5 °C.

In one embodiment, the susceptor may be a hollowed cylinder-shaped susceptor. For example, **FIG. 6** is a schematic diagram of a hollowed cylinder-shaped susceptor with enhanced thermal uniformity on the top surface with the radius and depth of the cylindrical hollow region dependent upon the material, frequency, and temperature, according to one or more embodiments of the present disclosure. As shown in **FIG. 6,** the susceptor may include a cylinder-shaped susceptor (e.g., cylindrical susceptor) 610 including a cylindrical hole 605. The hollowed cylinder-shaped susceptor may include a horizontal component 601 (e.g., horizontal plate) with a top surface 602 and a bottom surface 603, wherein the top surface 602 is configured to support a wafer 640 and a vertical rod 604 extending from the bottom surface 603 of the horizontal plate 601 along a longitudinal axis that is substantially perpendicular to the horizontal plate 601. The vertical rod 604 or cylindrical susceptor 610 includes a hollow region (e.g., cylindrical hole 605). An induction coil 630 may surround the cylindrical susceptor 610. In addition, a thermal insulator layer 620 may optionally separate the susceptor from the induction coil. The horizontal plate and vertical rod may both be a cylindrical symmetrical disk shape with the same radius.

In another embodiment, the susceptor may be a hollowed mushroom-shaped susceptor. For example, **FIG. 7** is a schematic diagram of a hollowed mushroom-shaped susceptor with enhanced thermal uniformity on the top surface with the radius and depth of the cylindrical hollow region dependent upon the material frequency, and temperature, according to one or more embodiments of the present disclosure. The mushroom-shaped susceptor shown in **FIG. 7** may comprise a horizontal component 701 (e.g., horizontal plate) with a top surface 702 and a bottom surface 703. The top surface 702 may be configured to support one or more wafers 740. A vertical component 704 (e.g., vertical rod or susceptor 710) may extend from the bottom surface 703 of the horizontal component 701 along a longitudinal axis that is substantially perpendicular to the horizontal component 701. The vertical component 704 may include a hollow region such as cylindrical hole 705. In general, the mushroom-shaped susceptor is similar to the cylindrical-shaped susceptor except the radius of the horizontal plate is greater than the radius of the vertical rod to produce the mushroom-shape. While the disclosure relates to cylindrical horizontal plates and vertical rods, the susceptors of the present disclosure may be fabricated in any shape.

The hollow regions of the hollowed cylinder-shaped susceptor and the mushroom-shaped susceptor may be characterized by four lengths: L1 refers to a radius of the cylindrical hollow region; L2 refers to a thickness of the vertical component (e.g., the difference between the radius of the cylinder-shaped susceptor and the radius of the cylindrical hollow region (L1)); L3 refers to the depth of the cylindrical hollow region; L4 refers to a thickness of the horizontal plate (e.g., the distance between the top surface and bottom surface) and L5 refers to the groove structure depth beneath the horizontal plate. As used herein, "L2" may refer to a thickness of a wall of the vertical rod. In many embodiments, the temperature distribution of the top surface of the susceptor may be improved by adjusting one or more of L1, L2, L3, L4, and L5. For example, the temperature distribution of the top surface of the susceptor may be made uniform and/or substantially uniform by adjusting one or more of L1 and L4. In another example, the temperature distribution may be substantially uniform and/or uniform for a 2-inch wafer on a Tungsten susceptor where L2 is about 5 mm and L3 is about 72 mm. For larger wafers, the temperature distribution on the top surface may be improved (e.g., more uniform, substantially uniform, and/or uniform) by increasing L2 and decreasing L3. Although the above discussion relates to L2 and L3 as design parameters, any of the three lengths (e.g., L1, L2, and/or L3) may be utilized in designing hollow susceptors.

In many embodiments, L2 and L3 may be adjusted to about the skin depth to effectively manipulate heat transfer and improve temperature uniformity on the top surface of the horizontal plate. For example, a hollow susceptor with a large L2 and large L3 generally has a lower temperature at the center of the top surface than solid susceptors. For example, **FIG. 8** is a graphical view of a temperature profile showing an improvement in temperature uniformity with an increase in L1, according to one or more embodiments of the present disclosure. Similarly, **FIG. 9** is a graphical view of a temperature profile showing an improvement in temperature uniformity with an increase in L3, according to one or more embodiments of the present disclosure.

Skin depth may be approximated as follows. Based on the classical electromagnetic theory, the skin depth can be calculated by the following formula:

$$\delta = \sqrt{\frac{\rho_T}{\pi f \mu}} \sqrt{\sqrt{1 + (2\pi f \rho_T \epsilon} + 2\pi f \rho_T \epsilon}$$

where $\rho_T$ is the resistivity of the conductor at temperature $T$, $f$ is the frequency of the applied AC power, $\mu$ is the permeability of the conductor, and $\varepsilon$ is the permittivity of the conductor. Because $2\pi f \rho_T \varepsilon$ is a small quantity for common induction heaters, this formula may be further reduced to

$$\delta = \sqrt{\frac{\rho_T}{\pi f \mu}} = 503.29 \sqrt{\frac{\rho_T}{f \mu_r}}$$

where $\mu_r$ is the relative permeability of the conductor. For most refractory conductors, $\rho_T$ is linearly proportional to the temperature, $T$, based on the formula

$$\rho_T = \rho_0 [1 + \alpha(T - T_0)]$$

where $\rho_0$ is the reference resistivity of the conductor at temperature $T_0$, and $\alpha$ is the resistivity temperature coefficient of the conductor. For all existing conductors, the magnetic properties are paramagnetic at temperatures above 1400°C and the relative permeability can be described by Curie's Law:

$$\mu_r = 1 + \frac{C}{T}$$

where C is the Curie Constant of the conductor. The skin depth may depend on frequency and temperature and may be described as

$$\delta = 503.29\sqrt{\frac{\rho_0[1 + \alpha(T - T_0)]}{f\left(1 + \frac{C}{T}\right)}}$$

This equation may be utilized in some embodiments to approximate the appropriate values for L2 and L3.

In some embodiments in which refractory conductors with high induction heating frequencies (e.g., about several thousand Hz) are utilized, skin depth is generally in the range of millimeters, which means that the inner region of the cylindrical-shaped solid susceptor is not affected by eddy current. In these embodiments, L2 should be greater than the skin depth because if L2 is less than or equal to the skin depth, the magnetic field may penetrate the hole and raise the surface temperature non-uniformly.

In an embodiment, a thickness of a wall of the vertical component is about greater than a skin depth. In an embodiment, a thickness of a wall of the vertical component is about equal to or less than a skin depth.

Temperature uniformity may be quantified by defining a uniformity length. In some embodiments, uniformity length may be defined as the length from the center of the horizontal component to a point at which a specified temperature difference has been observed. In an embodiment, the specified temperature difference may be observed at two points that do not include the temperature at the center point. For example, **FIG. 10A** is a graphical view showing the uniformity length of a 2" substrate, wherein the uniformity length is defined as the length from the center to another point at which there is a 5 °C temperature difference. In this figure, the 5 °C temperature difference is measured from a first non-center point to a second non-center point. **FIG. 10B** is a graphical view showing the uniformity length of a 2" substrate, wherein the uniformity length is similarly defined as the length from the center to another point at which there is a 5 °C temperature difference, except the 5 °C temperature difference is measured from the center point to a non-center point. In another embodiment, uniformity length is defined from the point with the highest temperature to the farthest point at which there is a 5 °C temperature difference. For example, **FIG. 10C** is a graphical view showing the uniformity length of a 2" substrate wherein the uniformity length is defined from the highest temperature to the farthest point which has a 5 °C temperature difference. In an embodiment, the uniformity length is less than about 10 inches, less than about 9 inches, less than about 8 inches, less than about 7 inches, less than about 6 inches, less than about 5 inches, less than about 4 inches, less than about 3 inches, less than about 2 inches, and/or less than about 1 inch.

**FIG. 11** is a graphical view showing how to define uniformity length on a 2" wafer, according to one or more embodiments of the present disclosure. The uniformity length, as illustrated in **FIG. 11** for example, refers to a region within which the temperature difference on the top surface is less than a given temperature range (e.g., 5°C) relative to the maximum temperature on the surface. For example, **FIG. 12** is a graphical view showing how uniformity length of a 2" wafer varies with increasing L1, according to one or more embodiments of the present disclosure. The temperature uniformity length shown in **FIG. 12** has a maximum length of about 2.13 cm (0.85 in) when L1 is about equal to 2 cm. This means that for a 2-inch wafer, 72.6% of the surface area has a temperature difference of less than about 5°C relative to the maximum surface temperature. Conversely, only about 12.1% of the surface area has a temperature difference of less than about 5°C relative to the maximum surface temperature in a solid susceptor with a uniformity length of about 0.87 cm (about 0.35 in.).

In some embodiments, a groove structure may be provided to provide greater control over heat transfer. **FIG. 13** is a schematic diagram of a mushroom-like susceptor with a groove structure 1350 beneath the horizontal plate 1301 for blocking heat transfer to the end/edge of the horizontal component, according to one or more embodiments of the present disclosure. As shown in **FIG. 13,** the susceptor may include a horizontal component 1301 (e.g., horizontal plate), wherein the horizontal component 1301 includes a top surface 1302, a bottom surface 1303, and grooves or groove structures 1350. The top surface 1302 may be configured to hold one or more wafers 1340. The vertical component 1304 (e.g., vertical rod) may extend from the bottom surface 1303 of the horizontal component 1301 along a longitudinal axis that is substantially perpendicular to the horizontal component 1301. The hollow region (not shown) may optionally be included in the vertical component 1304. A thermal insulator 1320 and induction coils 1330 may surround the vertical component 1304. In this way, the surface temperature may be controlled for hollowed susceptors with a deep hollow structure (e.g., a large L5). For example, **FIG. 14** is a graphical view of a temperature profile showing a rise in surface temperature with an increase in L5 which blocks heat transfer to the edge of the horizontal plate, according to one or more embodiments of the present disclosure.

In some embodiments, fillets on the corner of the hollow region may be utilized to improve heat transfer. For example, **FIG. 15** is a schematic diagram of a hollowed cylinder-shaped susceptor with enhanced thermal uniformity on the top surface with a fillet structure in a corner of the hollow region for enhanced heat transfer, according to one or more embodiments of the present disclosure. As shown in **FIG. 15,** the susceptor may include a horizontal component 1501 with a top surface 1502 and a bottom surface 1503, wherein the top surface 1502 is configured to hold one or more wafers 1540. A vertical component 1504 or cylindrical susceptor 1510 may extend from the bottom surface of the horizontal component 1501 along a longitudinal axis that is substantially perpendicular to the horizontal component 1501. A hollow region 1505 (e.g., cylindrical hole) may be within the vertical component 1504. The hollow region may include fillets 1560 with radius R. The fillets 1560 may be used to shape the hollow region nearest to the horizontal component of the susceptor. In this embodiment, a radius of the horizontal component may be about equal to the radius of the vertical component. The susceptor may further comprise a thermal insulator 1520 that surrounds the vertical component 1504 or cylindrical susceptor 1510. The susceptor may further comprise induction coil 1530 that surrounds the thermal insulator 1520.

Similarly, **FIG. 16** is a schematic diagram of a hollowed mushroom-shaped susceptor with enhanced thermal uniformity on the top surface with a fillet structure in a corner of the hollow region for enhanced heat transfer, according to one or more embodiments of the present disclosure. As shown in **FIG. 16,** the susceptor may include a horizontal component 1601 (e.g., horizontal plate) with a top surface 1602 and a bottom surface 1603, wherein the top surface 1602 is configured to support one or more wafers 1640. A vertical component (e.g., vertical rod) 1604 may extend from a bottom surface of the horizontal component 1601 along a longitudinal axis that is substantially perpendicular to the horizontal component 1601. A hollow region 1605 (e.g., cylindrical hole) may be within the vertical component 1604. The hollow region 1605 may include fillets 1660. The fillets 1660 may be used to shape the hollow region nearest to the horizontal component of the susceptor. In this embodiment, a radius of the horizontal component is greater than the radius of the vertical component, which gives rise, for example, to a mushroom-shaped susceptor. As in other embodiments, a thermal insulator 1620 and induction coil 1630 may surround the vertical component 1604. Filleted or rounded corners observe greater heat transfer efficiency compared to right-angle corners. By introducing fillet corners, the surface temperature may be controlled for hollowed susceptors with a deep hollow structure (e.g., a large L5). For example, **FIG. 17** is a graphical view of a temperature profile showing an improvement in heat transfer with an increase in R, according to one or more embodiments of the present disclosure.

The following Examples are intended to illustrate the above invention and should not be construed as to narrow its scope. One skilled in the art will readily recognize that the Examiners suggest many other ways in which the invention could be practiced. It should be understand that numerous variations and modifications may be made while remaining within the scope of the invention.

## EXAMPLE 1

### Optimized Susceptor

The following Example describes a solution to temperature non-uniformity. The solution may include creating a hole, or hollow region, in the vertical component of, for example, a mushroom-type susceptor (e.g., such as one where a radius of the horizontal component is greater than the vertical component). See **FIGS. 18A-18D,** for example, which are schematic diagrams of a mushroom-type susceptor showing (A)-(C) various cross-sectional views of a mushroom susceptor and (D) an isometric view of a mushroom-type susceptor, according to one or more embodiments of the present disclosure.

In particular, **FIG. 18A** is a schematic diagram of a cross-sectional view of a mushroom susceptor including horizontal component A, vertical component B, and hollow region C which is within the vertical component B. The parameters include L1, L2, L3, and L4, wherein L1 is defined as the radius of the vertical component, R; L2 refers to a thickness of the vertical component; L3 refers to the depth of the cylindrical hollow region; L4 refers to a thickness of the horizontal plate, H (e.g., the distance between the top surface and bottom surface). In an embodiment, L1 and L4 are parameters that are important to consider and/or adjust when improving temperature uniformity. **FIG. 18B** is a side view of a mushroom-type susceptor for a 2 inch wafer. **FIG. 18C** is an example of a mushroom-type susceptor in which L1 (e.g., R) and L4 (e.g., H) are optimized for a 2 inch wafer. **FIG. 18D** is an isometric view of a mushroom susceptor wherein A is the horizontal component (e.g., horizontal plate as shown) for blocking magnetic field during the induction heating, B is the vertical component (e.g., vertical rod as shown) for coupling with the induction coil, and C is a pocket for placing the wafer.

## EXAMPLE 2

### Evaluation and Performance of Mushroom-Shaped Susceptors

Computer simulations were used to evaluate and compare the performance of susceptors with and without hollow regions. In some instances, the performance of susceptors with the induction coils shifted downward, and susceptors with both the induction coils shifted downward and a hollow region were evaluated and compared. Data from the computer simulations is presented for mushroom-shaped susceptors for 2 inch, 4 inch, 6 inch, and 8 inch substrates. The mushroom-shaped susceptors were heated by induction heater.

Mushroom-Shaped Susceptor for 2" Substrate

Data from the computer simulation of a mushroom-shaped susceptor for a 2 inch substrate heated by induction heater is presented in **FIGS. 19-21.**

**FIGS. 19** and **20** present data for the mushroom-shaped susceptor without and with a hollow region, respectively, In particular, **FIGS. 19A-19B** show (A) a schematic diagram of a mushroom-type susceptor for a 2 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure. As shown in **FIG. 19B,** at Z = 7, the temperature non-uniformity can be observed.

**FIGS. 20A-20B** show (A) a schematic diagram of a mushroom-type susceptor for a 2 inch substrate with a hollow region, where Z = 2 to 7 identify positions that correspond to cross-section temperature profiles shown in (B), and (B) is a graphical view of the cross-section temperature profiles of the susceptor at corresponding positions Z = 2 to 7, according to one or more embodiments of the present disclosure. As shown in **FIG. 20B,** at Z = 7, the temperature non-uniformity is improved.

The performance of the mushroom-shaped susceptor for a 2 inch substrate at different R (radius of hollow region) and H (thickness of horizontal component) was evaluated to optimize temperature uniformity. **FIGS. 21A-21B** show, for a susceptor for a 2 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure. The best temperature uniformity was observed for the susceptor when R = 20 mm and H = 12.5 mm.

**FIG. 22** is a graphical view of uniformity length (left y-axis) and percent of substrate area with temperature non-uniformity less than 5 °C (right y-axis) versus temperature, according to one or more embodiments of the present disclosure. This figure makes clear that when R and H are optimized at high temperature, the temperature uniformity at low temperature is even better.

Mushroom-Shaped Susceptor for 4" Substrate

Data from the computer simulation of a mushroom-shaped susceptor for a 4 inch substrate heated by induction heater is presented in **FIGS. 23-26.** In particular, a mushroom-shaped susceptor without a hollow region (**FIG. 23**), with the induction coils shifted downward (**FIG. 24**), and with both a hollow region and the induction coils shifted downward (**FIG. 25**), were evaluated and optimized in **FIG. 26.**

In particular, **FIGS. 23A-23B** show (A) a schematic diagram of a mushroom-type susceptor for a 4 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure. As shown in **FIG. 23B,** at Z = 7, the temperature non-uniformity is acceptable.

**FIGS. 24A-24B** show (A) a schematic diagram of a mushroom-type susceptor for a 4 inch substrate with the induction coils shifted downward, where Z = 2 to 8 identify positions that correspond to cross-section temperature profiles shown in (B), and (B) is a graphical view of the cross-section temperature profiles of the susceptor at corresponding positions Z = 2 to 8, according to one or more embodiments of the present disclosure. As shown in **FIG. 24B,** at Z = 8, the temperature non-uniformity gets worse. While shifting the induction coils downward for a 4 inch substrate may not be advisable, it can benefit temperature non-uniformity for larger substrates, such as 6 inch and/or 8 inch substrates.

**FIGS. 25A-25B** show (A) a schematic diagram of a mushroom-type susceptor for a 4 inch substrate with a hollow region and the induction coils shifted downward, where Z = 2 to 8 identify positions that correspond to cross-section temperature profiles shown in (B), and (B) is a graphical view of the cross-section temperature profiles of the susceptor at corresponding positions Z = 2 to 8, according to one or more embodiments of the present disclosure. As shown in **FIG. 25B,** shifting the induction coils downward and including a hollow region can benefit and/or improve temperature uniformity.

The performance of the mushroom-shaped susceptor for a 4 inch substrate at different R (radius of hollow region) and H (thickness of horizontal component) was evaluated to optimize temperature uniformity. **FIGS. 26A-26B** show, for a susceptor for a 4 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various H (thicknesses of the horizontal component), according to one or more embodiments of the present disclosure. The best temperature uniformity was observed for the susceptor when R = 44 mm and H = 30 mm and the induction coil was shifted 10 mm downward.

Mushroom-Shaped Susceptor for 6" Substrate

Data from the computer simulation of a mushroom-shaped susceptor for a 4 inch substrate heated by induction heater is presented in **FIGS. 27-30.** In particular, a mushroom-shaped susceptor without a hollow region (**FIG. 27**), with the induction coils shifted downward (**FIG. 28**), and with both a hollow region and the induction coils shifted downward (**FIG. 29**), were evaluated and optimized in **FIG. 30.**

In particular, **FIGS. 27A-27B** show (A) a schematic diagram of a mushroom-type susceptor for a 6 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure. As shown in **FIG. 27B,** at Z = 7, the temperature non-uniformity can be observed.

**FIGS. 28A-28B** show (A) a schematic diagram of a mushroom-type susceptor for a 6 inch substrate with the induction coils shifted downward, where Z = 2 to 10 identify positions that correspond to cross-section temperature profiles shown in (B), and (B) is a graphical view of the cross-section temperature profiles of the susceptor at corresponding positions Z = 2 to 10, according to one or more embodiments of the present disclosure. As shown in **FIG. 28B,** at Z = 10, the temperature non-uniformity is improved. Shifting the induction coil downward can benefit the temperature uniformity, and the improvement can be better once a hollow region is created in the vertical component.

**FIGS. 29A-29B** show (A) a schematic diagram of a mushroom-type susceptor for a 6 inch substrate with a hollow region and the induction coils shifted downward, where Z = 2 to 10 identify positions that correspond to cross-section temperature profiles shown in (B), and (B) is a graphical view of the cross-section temperature profiles of the susceptor at corresponding positions Z = 2 to 10, according to one or more embodiments of the present disclosure. As shown in **FIG. 29,** at Z = 10, the temperature non-uniformity is improved. Shifting induction coil downward and creating a hollow region in the vertical component can benefit the temperature uniformity.

The performance of the mushroom-shaped susceptor for a 6 inch substrate at different R (radius of hollow region) and H (thickness of horizontal component) was evaluated to optimize temperature uniformity. **FIGS. 30A-30B** show, for a susceptor for a 6 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure. The best temperature uniformity was observed for the susceptor when R = 65 mm and H = 50 mm and the induction coil was shifted 40 mm downward.

Mushroom-Shaped Susceptor for 8" Substrate

Data from the computer simulation of a mushroom-shaped susceptor for an 8 inch substrate heated by induction heater is presented in **FIGS. 31-34.** In particular, a mushroom-shaped susceptor without a hollow region (**FIG. 31**), with the induction coils shifted downward (**FIG. 32**), and with both a hollow region and the induction coils shifted downward (**FIG. 33**), were evaluated and optimized in **FIG. 34.**

In particular, **FIGS. 31A-31B** show (A) a schematic diagram of a mushroom-type susceptor for a 8 inch substrate without a hollow region, where Z = 1 to 7 identify positions that correspond to cross-section temperature profiles shown in (B), and (B) is a graphical view of the cross-section temperature profiles of the susceptor at corresponding positions Z = 1 to 7, according to one or more embodiments of the present disclosure. As shown in **FIG. 31B,** at Z = 7, the temperature non-uniformity can be observed.

**FIGS. 32A-32B** show (A) a schematic diagram of a mushroom-type susceptor for a 8 inch substrate with the induction coils shifted downward, where Z = 2 to 13 identify positions that correspond to cross-section temperature profiles shown in (B), and (B) is a graphical view of the cross-section temperature profiles of the susceptor at corresponding positions Z = 2 to 13, according to one or more embodiments of the present disclosure. As shown in **FIG. 32B,** at Z = 13, the temperature non-uniformity is improved. Shifting induction coil downward can benefit the temperature uniformity, and the improvement can be better once a hollow region is created in the vertical component.

**FIGS. 33A-33B** show (A) a schematic diagram of a mushroom-type susceptor for a 8 inch substrate with a hollow region and the induction coils shifted downward, where Z = 2 to 13 identify positions that correspond to cross-section temperature profiles shown in (B), and (B) is a graphical view of the cross-section temperature profiles of the susceptor at corresponding positions Z = 2 to 13, according to one or more embodiments of the present disclosure. As shown in **FIG. 33B,** at Z = 13, the temperature non-uniformity was improved. Shifting the induction coil downward and creating the hollow region in the vertical component can benefit the temperature uniformity.

The performance of the mushroom-shaped susceptor for an 8 inch substrate at different R (radius of hollow region) and H (thickness of horizontal component) was evaluated to optimize temperature uniformity. **FIGS. 34A-34B** show, for a susceptor for a 8 inch substrate, (A) a graphical view of uniformity length (left y-axis) and percent of substrate area with temperature non-uniformity less than 5 °C (right y-axis) versus R (radius of hollow region); and (B) a graphical view of uniformity length versus R (radius of hollow region) for various thicknesses of the horizontal component, according to one or more embodiments of the present disclosure. The best temperature uniformity was observed for the susceptor when R = 82 mm and H = 70 mm and the induction coil was shifted 60 mm downward.

Other embodiments of the present disclosure are possible. Although the description above contains much specificity, these should not be construed as limiting the scope of the disclosure, but as merely providing illustrations of some of the presently preferred embodiments of this disclosure. One skilled in the art will readily recognize that the Examiners suggest many other ways in which the invention could be practiced. It should be understand that numerous variations and modifications may be made while remaining within the scope of the invention. It is also contemplated that various combinations or sub-combinations of the specific features and aspects of the embodiments may be made and still fall within the scope of this disclosure. It should be understood that various features and aspects of the disclosed embodiments can be combined with or substituted for one another in order to form various embodiments. Thus, it is intended that the scope of at least some of the present disclosure should not be limited by the particular disclosed embodiments described above.

Thus the scope of this disclosure should be determined by the appended claims and their legal equivalents. Therefore, it will be appreciated that the scope of the present disclosure fully encompasses other embodiments which may become obvious to those skilled in the art, and that the scope of the present disclosure is accordingly to be limited by nothing other than the appended claims, in which reference to an element in the singular is not intended to mean "one and only one" unless explicitly so stated, but rather "one or more." All structural, chemical, and functional equivalents to the elements of the above-described preferred embodiment that are known to those of ordinary skill in the art are expressly incorporated herein by reference and are intended to be encompassed by the present claims. Moreover, it is not necessary for a device or method to address each and every problem sought to be solved by the present disclosure, for it to be encompassed by the present claims. Furthermore, no element, component, or method step in the present disclosure is intended to be dedicated to the public regardless of whether the element, component, or method step is explicitly recited in the claims.

The foregoing description of various preferred embodiments of the disclosure have been presented for purposes of illustration and description. It is not intended to be exhaustive or to limit the disclosure to the precise embodiments, and obviously many modifications and variations are possible in light of the above teaching. The example embodiments, as described above, were chosen and described in order to best explain the principles of the disclosure and its practical application to thereby enable others skilled in the art to best utilize the disclosure in various embodiments and with various modifications as are suited to the particular use contemplated. It is intended that the scope of the disclosure be defined by the claims appended hereto.


**EXAMPLE 3**


The induction heating is a common method applied in metalorganic vapor phase epitaxy (MOVPE) especially for higher-temperature growth conditions. However, compared to the susceptor heated by the multiple-zone resistant heater, the inductive-heated susceptor could suffer from severe thermal non-uniformity issue. In this simulation study, we propose to employ a T-shape susceptor design with various geometric modifications to significantly improve the substrate temperature uniformity by manipulating thermal transfer. Specifically, the thermal profile can be tailored by horizontal expansion and vertical elongation of the susceptor, or forming a cylindrical hollow structure at the susceptor bottom cylinder. Three optimized designs are shown with different temperature uniformity as well as various induction heating efficiencies. The temperature variation of the entire substrate surface can be less than 5 °C at ~1900 °C with high induction heating efficiency after applying the proposed techniques.


**1. Introduction**

Ultra-wide bandgap III-nitride materials including AlN, BN, and their alloys with other group-III elements are promising for optoelectronics and power electronics applications. High material quality of these alloys is essential for device performance and investigation of material properties. However, it has been challenging to realize it especially on commercially-viable foreign substrates including sapphire and silicon primary due to large lattice mismatch. The metalorganic vapor phase epitaxy (MOVPE) is the most common method for growing III-nitride materials. To improve quality of the ultra-wide bandgap III-nitride materials such as AlN, MOVPE growers have employed various methods including precursor pulsing to enhance adatom movement and patterned substrates to leverage lateral coalescence. Another notable method is to apply extremely high temperature (EHT) (> 1600 °C) to enhance adatom mobility and suppress undesirable impurity incorporation, which has led to greatly improved material quality.

However, existing commercial MOVPE systems with the resistant heater may not be suitable for long-term and low-cost EHT operation. The filament of the resistant heater is usually made of refractory metals such as tantalum (Ta), tungsten (W), rhenium (Re), or their alloys which can sustain high temperature while emitting thermal radiation. Ideally, the heated susceptor can absorb all the thermal radiation and reach thermal equilibrium temperature according to its emissivity and absorptivity ratio according to the Kirchhoff's law of thermal radiation. However, in reality the susceptor both absorbs and reflects thermal radiation. The susceptor reflects even more thermal radiation at higher temperatures. Therefore, the filament usually needs to be several hundred degrees higher than the susceptor target temperature; otherwise, the susceptor could not reach the target temperature. At higher temperatures, the filament has thermal expansion and can cause warpage and possibly short circuit. Moreover, though refractory metals have high melting point, extreme heating-and-cooling cycles can cause thermal fracture and may break the filament eventually.

Compared to the resistant heater, the induction heater has several advantages due to a different working principle. The induction coil generates alternating magnetic field and the susceptor induces Eddy current accordingly, i.e. inductive coupling. The Eddy current causes the Joule heating effect on the susceptor and heats up the susceptor. Unlike the resistant heater, such energy transfer mechanism is independent of temperature, meaning there is no thermal radiation reflection, warpage, or lifetime issue. That's the reason for the induction heater to have good heating efficiency and higher reliability than the resistant heater. Nevertheless, the induction heater also has drawbacks. The inductive coupling efficiency between the induction coil and the susceptor is affected by induction coil geometry, susceptor geometry, susceptor material, and frequency of AC power load. Furthermore, the induction heater could result in severe temperature non-uniformity for conventional column-shape susceptors as compared to the resistant heater. Large temperature non-uniformity can cause problems because it affects metalorganic compound pyrolysis efficiency, material composition, growth rate, adatom mobility, and wafer curvature.

The resistant heater users can apply the multi-zone technique to tune the substrate temperature uniformity. However, it is difficult to apply the multi-zone technique for the induction heater. There have been studies that propose techniques to improve substrate temperature uniformity of the induction-heated susceptor. But these techniques are often complicated or not applicable for EHT. In the previous report, an MOVPE reactor design was proposed by having the induction coil placed around the bottom cylinder under the top plate of a T-shape susceptor as shown in Figure 35(a). Hence, the magnetic field is nearly fully coupled to the susceptor to greatly improve induction heater efficiency at EHT and allow the use of small susceptor-gas inlet distance because of the magnetic shielding effect of the T-shape susceptor. Thus, the proposed reactor could reach higher temperatures and possess lower parasitic reaction rates for Al- and B-containing metalorganic precursors which are desirable for MOVPE processes of the ultra-wide bandgap III-nitride materials. Despite these technical advantages, the T-shape susceptor also suffers from the temperature non-uniformity issue that ought to be addressed for growing high quality and uniform epitaxial wafers.

In this work, the substrate temperature uniformity of the T-shape susceptor has been studied. The substrate temperature uniformity can be improved via controlling the heat transfer path by vertically elongating the susceptor, horizontally expanding the susceptor, or forming a cylindrical hollow structure on the bottom of the susceptor, as shown in Figure 35(b). The induction heating efficiency has also been investigated.

Figure 35 (a) The reference T-shape susceptor with set dimensions of $A_O$ = 1.8 cm, $B_O$ = 1 cm, $C_O$ = 5 cm, and $F_O$ = 2.5 cm (one inch). (b) The optimized T-shape susceptor with geometric variables. Both susceptors can accommodate a two-inch susceptor. Variables R and D in (b) are the radius and depth of the cylindrical hollow structure, respectively. Variable E is the radius increase of the susceptor and variable L is the height increase of the bottom cylinder. The black arrows indicate the heat transfer path.

## 2. Materials and Methods

The heat transfer simulation was conducted using the cylindrical symmetry because of the axial symmetry of the susceptors. The susceptors were assumed to accommodate a two-inch substrate. Similar works can be conducted on the larger susceptors and thus they are not included in this report. The reference T-shape susceptor in Figure 35(a) is a solid piece comprising a top plate and a bottom cylinder with set dimensions where the bottom cylinder is directly below the two-inch substrate pocket. The optimized T-shape susceptor in Figure 35(b) is similar to the reference T-shape susceptor in terms of the overall shape but have four geometric dimension variables: R and D are radius and height of the cylindrical hollow structure within the bottom cylinder; E is the radial increase of the top plate and the bottom cylinder; and L is the height increase of the bottom cylinder. The position of induction coil can influence the induction coupling. For the reference and optimized T-shape susceptors, the edge of the lowest coil always align with the bottom surface of the bottom cylinder.

The numerical calculations were carried out by using the finite element analysis of the COMSOL Multiphysics 4.3a. The mesh included 139,656 triangular elements and 191,043 degrees of freedom. Heat transfer by thermal radiation, conduction, and induction heating was simulated by the build-in models. Most commercial induction heaters operate at frequencies of 1-30 kHz. In this work, the frequency was fixed at 10 kHz. Most EHT susceptors are made of (crystalline or amorphous) graphite coated by silicon carbide (SiC) or tantalum carbide (TaC). However, in this work, the proposed T-shape susceptor is made of tungsten (W) due to its low cost, high melting point, and superior isotropic electric conductivity and thermal conductivity. TaC is an excellent material for induction-heated high temperature applications but TaC has higher cost than graphite and W. The crystalline graphite has in-plane and out-of-plane lattice planes, which makes it an anisotropic material. The in-plane electric and thermal conductivities are similar to the tungsten's, depending on the quality of graphite. However, the out-of-plane electric and thermal conductivities are inferior to the tungsten's. Such anisotropic properties affect inductive coupling efficiency and heat transfer. The amorphous graphite is a porous material with poor electric and thermal conductivity. It can lead to poor inductive coupling efficiency that is detrimental for heating efficiency at EHT. Hence, tungsten is a good candidate for inductively-heated high-temperature and low-cost susceptors. All the physical quantities of tungsten required in the simulation can be found in the *CRC Handbook of Chemistry and Physics.*

The temperature distribution on the induction-heated susceptor depends on heat transfer. For the induction heating modeling, the governing equation is:

$$[\nabla^2 + \mu_0\mu_r(\epsilon_0\epsilon_r\omega^2 - i\sigma\omega)]\vec{A} = \mu_0\mu_r(\sigma + i\epsilon_0\epsilon_r\omega)\frac{V_{coil}}{2\pi R}\hat{\phi}, \qquad (1)$$

where $i$ is imaginary number, $\sigma$ is the electrical conductivity, $\omega$ is angular frequency of alternating current, $\eta$ is resistivity of material, $\varepsilon_0$ is electrical permeability at free space, $\varepsilon_r$ is relative electrical permittivity, $\vec{A}$ is magnetic vector potential, $\mu_0$ is magnetic permeability at free space, and $\mu_r$ is relative magnetic permeability. The induction coil was modeled as torus shape, meaning $\vec{\nabla}V = \frac{V_{coil}}{2\pi R}\hat{\phi},$ where $V_{coil}$, $R$, and $\hat{\phi}$ are the electric potential, the radius of the induction coil, and the unit vector, respectively.

For thermal conduction modeling, the governing equation is:

$$\rho C_P\frac{\partial T}{\partial t} + \rho C_P\vec{u}\cdot\vec{\nabla}T = \vec{\nabla}\cdot\left(k\vec{\nabla}T\right) + Q, \qquad (2)$$

where $\rho$ is density, $C_P$ is the specific heat capacity at a constant pressure, $T$ is absolute temperature, t is time, $\vec{u}$ is velocity vector, $k$ is thermal conductivity, and $Q = \frac{1}{2}\text{Re}\left(\vec{J}\cdot\vec{E}\right)$ is the heat power generated by the Eddy current.

For thermal radiation modeling, the governing equations are:

$$-\vec{n}\cdot\vec{q} = G - J, \qquad (3)$$

$$(1 - \varepsilon)G = J - E_b(T), \qquad (4)$$

$$E_b(T) = \varepsilon\sigma T^4, \qquad (5)$$

where $\vec{n}$ is the normal vector on the boundary, $\vec{q}$ is the radiation heat flux vector, $G$ is incoming radiative heat flux, $J$ is the total outgoing radiative heat flux, $\varepsilon$ is the emissivity of the material, $E_b(T)$ is the blackbody hemispherical total emissive power, and $\sigma$ is the Stefan-Boltzmann constant.

From the simulation results, the radius and the depth of the hollow structure, and horizontal expansion and vertical elongation of the susceptor can significantly influence the substrate temperature uniformity. The mechanism and optimized parameters for the T-shape susceptor will be discussed thoroughly in the next sections.

To quantify the substrate temperature uniformity, we define a value called the *Uniformity Length* (UL) as *the distance from the substrate center to the farthest point within which the substrate surface temperature variation is equal or less than 5 °C.* Thus, the larger the UL, the better the substrate temperature uniformity is. For a two-inch substrate, the maximum UL in the ideal situation is one inch where the temperature difference of the entire substrate is less than 5 °C. Although temperature variation on a wafer in a state-of-the-art MOVPE reactor could be less than 5 °C at lower growth temperatures such as -1000 °C for InGaN light emitters, the threshold of 5 °C was reasonable because the target is EHT in this study. In other words, a 5 °C difference represented a very small, if not negligible temperature non-uniformity budget at EHT. Figure 36(a) and 36(b) include a convex and a camel-back temperature line profile, respectively, where the UL's are shown as examples. In the following sections, the simulation results related to 37, 39, and 40 have the same induction heating power of 6.5 kW, but the substrate average temperature is not the same. It is because heat transfer path and induction heating coupling are geometry dependent.

Figure 36 (a) and (b) show the UL's with convex and camel-back substrate surface temperature line profiles, respectively. The zero on the *x*-axis represents the substrate center.

### 3.1 Temperature profile of the reference T-shape susceptor

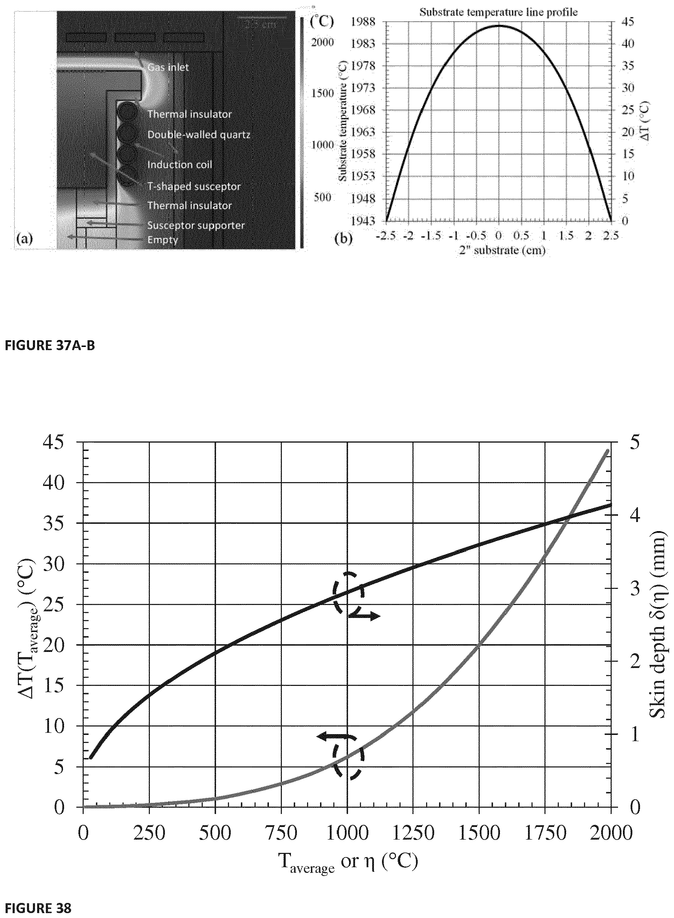

The cross-sectional temperature profile of the reference T-shape susceptor in the reactor is shown in Figure 37(a). Due to the reactor's axial symmetry, only half of the cross section is shown. The detail reactor configuration can be find elsewhere. The bottom cylinder temperature is higher than the top plate temperature, because the heat transfer is mainly from the bottom cylinder to the top plate. To keep such heat transfer path, the heat transferred downward to the susceptor supporter (made of Molybdenum) and heat released by thermal radiation have to be reduced. Otherwise, these heat sinks will affect the heating efficiency of the susceptor. To reduce the heat sink, several thermal insulators (made of zirconia) are placed on the lateral and bottom sides of the bottom cylinder. The lateral thermal insulator not only reduces thermal radiation, but also protects the induction coil from thermal radiation. The bottom thermal insulator blocks the heat transferring downward to the susceptor supporter.

Figure 37 (a) The cross-sectional temperature profile of half of the reference T-shape susceptor in the reactor. (b) The substrate line temperature line profile of the two-inch substrate measured from the blue dash line in (a) with $T_{center}$ of 1987 °C.

The substrate temperature line profile is shown in 37(b). The average substrate temperature ($T_{average}$) is 1972 °C with the standard deviation ($\sigma$) of 13.5 °C. The temperature difference ($\Delta T = T_{center} - T_{edge}$) between the susceptor center ($T_{center}$) and the susceptor edge ($T_{edge}$) is as large as 45 °C which is not acceptable. The red curve of 38 shows that Figure 38$\Delta T$ a quadratic function of $T_{center}$. When $T_{center}$ is 1000 °C, $\Delta T$ is ~5 °C which is still acceptable. However, $\Delta T$ rapidly increases to over 25 °C above the EHT, suggested that the reference T-shape susceptor design be modified to be applicable for acceptable uniformity at EHT.

To develop techniques improving the substrate temperature uniformity, understanding the induction heating mechanism and the heat transfer in the T-shape susceptor is important. Based on classical electrodynamics, EM waves only reach a certain depth below a conductor surface and the depth is defined as the skin depth ($\delta$), which can be calculated by the following formula,

$$\delta = \sqrt{\frac{\rho_\eta}{\pi f \mu_o \mu_r}} \sqrt{\sqrt{1 + \left(2\pi f \rho_\eta \epsilon_0 \epsilon_r\right)^2} + 2\pi f \rho_\eta \epsilon_0 \epsilon_r}, \ (6)$$

where *f* is the frequency of the alternating current, $\varepsilon_0$ is the electrical permeability at free space, $\varepsilon_r$ is the relative electrical permittivity, $\mu_0$ is the magnetic permeability at free space, $\mu_r$ is the relative magnetic permeability, and $\rho_\eta$ is the resistivity of the conductor at temperature $\eta$. Because $2\pi f \rho_\eta \varepsilon_0 \varepsilon_r$ is a small quantity for common induction heaters frequency and metal, Equation (6) can be further reduced to:

$$\delta(\eta) \approx \sqrt{\frac{\rho_\eta}{\pi f \mu_0 \mu_r}} \approx 503.29 \sqrt{\frac{\rho_0 [1 + \alpha(\eta - \eta_0)]}{f}}, \quad (7)$$

where $\rho_0$ is the reference resistivity of the conductor at temperature $\eta_0$ (300K) and $\alpha$ is the temperature coefficient of resistivity. Tungsten is a paramagnetic material which can be consider as low-level magnetization, and paramagnetic property can be described by the Curie's Law. Therefore without large deviation, $\mu_r$ can be approximately considered as one. From Equation (7), $\delta$ depends on the electrical properties of the conductor, the frequency of the induction heater, and the temperature of the susceptor.

Figure 38 (Red curve) The temperature difference ($\Delta T$) between $T_{center}$ and $T_{edge}$ of the reference T-shape susceptor as a function of $T_{average}$. (Black curve) Skin depth as a function of the temperature $\eta$.

The skin depth vs temperature $\eta$ was further calculated and shown in 38. The skin depth gradually increases from 1.1 to 4 mm when temperature increases from 100 to 2000 °C. The magnetic field intensity decays exponentially when the magnetic field penetrates into the T-shape susceptor ($\sim e^{x/\delta}$). When the magnetic field penetrates one skin depth distance from the surface, the intensity decays to 36.7% ($\sim e^{-1}$), and decays to 13.5% ($\sim e^{-2}$) and 4.9% ($\sim e^{-3}$) when the penetration distances are two and three skin depth, respectively. Therefore within the distance of three skin depths from the surface, the bottom cylinder will induce most of the Eddy current and generate an internal magnetic field against the external magnetic field by the Faraday-Lenz law of induction. The Eddy current encircles the bottom cylinder and generates heat by the Joule-Lenz law. The skin depth at 1900 °C is 4 mm from Figure 38, which means that from the bottom cylinder surface to 1.2 cm below, the Eddy current will be induced to generate heat. Once the generated heat transfers to the top plate surface, the temperature of the outer region of the bottom cylinder near the surface is lower than that of the inner region. It is because the outer region will release heat by radiating thermal radiation and conducting to the thermal insulator. Furthermore, when the heat approaches the top plate surface, part of the heat goes to the susceptor ear (Figure 35), making the outer region of the bottom cylinder release more heat.

The heat transfer behaviors explain that the two-inch substrate has higher $T_{center}$ and lower $T_{edge}$ [Figure 37(b)], and the temperature difference between the center and the edge increases as the average temperature goes higher. The substrate temperature line profile [Figure (b)] has a UL of 0.92 cm, which corresponding to 13.5% temperature uniformity on the substrate surface $[(\frac{0.92\,cm}{2.5\,cm})^2 \sim 13.5\%]$. Such uniformity is not acceptable. However, it can be improved by geometric modification techniques in Section 3.2.

## 2.2 Impacts of geometric options on substrate temperature uniformity

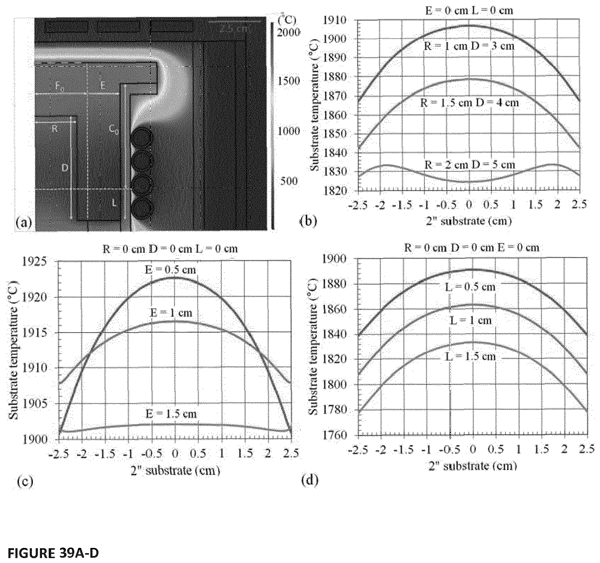

In this section, out of the geometric options, i.e. the formation of the hollow structure (R and D), the radius increases of the top plate and the bottom cylinder (E), and the bottom cylinder elongation (L), only one is implemented at one time while others are the same as the reference susceptor. After the impact of each option is known, it helps further improving the substrate temperature uniformity when multiple variables are involved (Section 3.3). Figure 39(b) presents the substrate temperature line profile at different R and D values, while keeps E and L zero. Figure 39(c) exhibits the substrate temperature line profile evolution at various E values, while R, D, and L are zero. Figure 39(d) shows the impact of L while R, D, and E are zero. The three options are found to significantly impact the heat transfer path and the substrate temperature uniformity.

In Figure 39 (b), the substrate temperature line profile shifts downward when R and D increase. Meanwhile, the substrate temperature uniformity gradually improves. For instance, when R is 2 cm and D is 5 cm (blue curve) shows superior substrate temperature uniformity to red and green curves. The explanation is that when there is a hollow structure in the bottom cylinder, the heat transfer is not simply from the entire bottom cylinder to the top plate, since the inner region of the bottom cylinder is empty, as shown in Figure 35(b). When R and D increase, more heat starts to transfer from the side of the bottom cylinder to the center of the bottom cylinder. Such a shift of the heat transfer results in the substrate temperature drop at the center. Since the substrate temperature at the center was higher than the substrate temperature on the edge, the substrate temperature uniformity can be improved by forming the hollow structure.

In Figure 39(c), the substrate temperature line profile evolves with different values of E. The substrate temperature line profile shifts downward with increasing E, while the temperature difference between the center and the edge reduces and achieves acceptable substrate temperature uniformity when E is 1.5 cm. In Section 3.1, the substrate temperature difference between the substrate center and edge can be explained by different heat transfer paths between the bottom cylinder inner and outer regions. Here, a larger diameter keeps the bottom cylinder inner region away from the outer region. Hence, the heat transferring to the top plate surface is mainly from the bottom cylinder inner region. Since the temperature in the bottom cylinder inner region is much uniform than that in the bottom cylinder outer region, the temperature uniformity is improved.

In Figure 39(d), interestingly, the substrate temperature line profile shifts downward without alternating its shape. Also, the profile drops almost linearly (about 30 °C for every 0.5 cm increase in L). This is because the vertical elongation does not change the heat transfer path. The bottom cylinder outer region still has a faster heat lost rate than that of the bottom cylinder inner region. Furthermore, since the induction coil also shifts downward amid the vertical elongation, the heat generated in the bottom cylinder is even farther away from the top plate surface, which makes the heat transfer path longer. Therefore, the substrate temperature line profile shifts downward without improvement or deterioration of the substrate temperature uniformity. By studying how the temperature line profile is affected by R, D, E, and L, it is obvious that R, D, and E can improve the uniformity greatly if appropriate R, D, and E are chosen. On the other hand, L is not useful.

Figure 39 (a) The cross-sectional temperature profile of half of T-shape susceptor in the reactor. The vertical yellow dash line shows the original radius of the bottom cylinder. The horizontal yellow dash line shows the original bottom edge of the bottom cylinder before elongation. The red solid line on the up-right corner is a scale bar. (b), (c), and (d) show different substrate temperature line profiles by adjusting R and D, E, and L, respectively, while fixing the other variables as shown on the top of each figure.

The current section (3.2) discusses the impacts of the three geometric options. But they are not fully optimized even though some examples in Figure 39 show better substrate temperature uniformity. To further improve the substrate temperature uniformity, R, D, and E have to be optimized according to the temperature standard deviation, the UL, and the susceptor volume. In Section 3.3, three optimized designs (Designs 1-3) are shown and discussed with their own benefits and drawbacks.

## 3.3 Comparison between three optimized designs

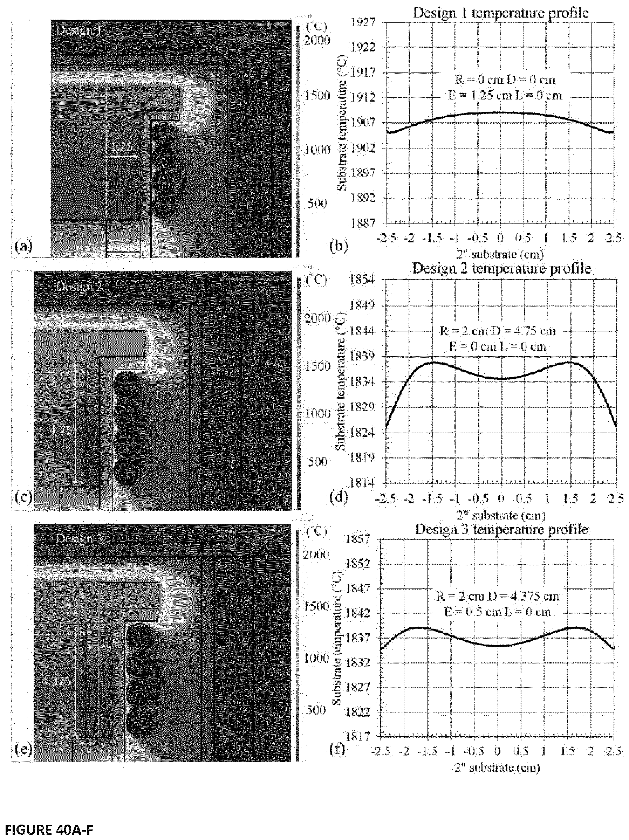

The optimization follows one major rule: it has to keep the UL as large as possible. The maximum is 2.5 cm. On top of that, if there are multiple optimized setups which leads to the same UL, the susceptor volume is preferably smaller, which is related to heating efficiency at the EHT. It is important to note that the difference in the required induction power may not be large in this study between the two-inch substrate susceptors. But it would be expectedly significant for larger susceptors particularly the ones used for production. The substrate temperature line profile of Design 1 is shown in Figure 40(b). It is apparent that the substrate temperature uniformity matches the criteria ($\Delta T \leq 5$ °C). Its substrate average temperature is 1907 °C, the temperature standard deviation is 1.0 °C, and the UL is 2.5 cm covering the entire substrate. For Design 2 [Figure 40(d)], its substrate temperature uniformity is not as good as Design 1. Design 2 has average substrate temperature of 1835 °C, the temperature standard deviation of 3.1 °C, and the UL of 2.1 cm covering 71% of the substrate surface. The reduced UL is caused by an unfavorable substrate temperature drop ($\sim$13 °C) near the substrate edge. For Design 3 [Figure 40 (e)], it has the substrate average temperature of 1837 °C, the temperature standard deviation of 1.4 °C, and the UL of 2.5 cm covering the entire substrate.

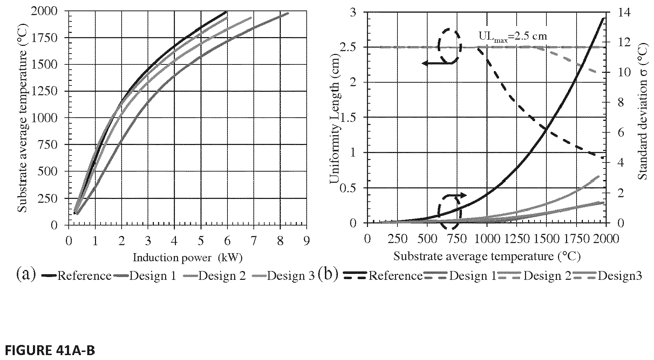

Through optimizing horizontal expansion only, Design 1 seems to be better than Design 2 optimizing the hollow structure only. However, there is a drawback. The substrate temperature uniformity is improved by increasing the radius versus the reference substrate. This causes the volume of Design 1 is roughly twice larger than that of the reference substrate. Thus, Design 1 requires more induction power. For instance, Design 1 requires 6.4 kW at 1750 °C while the reference susceptor needs only 4.4 kW [Figure 41(a)]. The uniformity of Design 2 is poorer. However, it has the closest heating efficiency to that of the reference substrate. For Design 1 and Design 2, there is a tradeoff between the temperature uniformity and the heating efficiency. It is possible to have a compromised design, which means excellent temperature uniformity and high heating efficiency, i.e. Design 3. Design 3 leads to the same UL as Design 1. Since Design 3 has larger standard deviation than Design 1's, Design 1's temperature uniformity is better. But Design 3 has considerably higher heating efficiency than that of Design 1, as shown in Figure 41(b).

Figure 40 (a), (c), and (e) are the temperature profiles of the optimized T-shape susceptors Design 1-3, respectively. The unit of the numbers is cm. (b), (d), and (f) are the substrate temperature line profiles of Design 1-3, respectively.

Figure 41 (a) The substrate average temperature of different designs as a function of the induction power, indicating various heating efficiencies. (b) The UL and the standard deviation of the substrate temperature as a function of the substrate average temperature.

The UL and the standard deviation of the substrate temperature as a function of the substrate average temperature of the three designs are shown in Figure 41(a). For Design 1 and Design 3, the UL is 2.5 cm amid the entire temperature range indicating their excellent candidacy for the temperature uniformity. For Design 2, the UL is 2.5 cm until reaching temperatures over $\sim$1500 °C, which means that it is perfect for lower temperatures but not good for the EHT. The UL of the reference susceptor starts to decrease at 900 °C which is even lower than the conventional growth temperature of GaN ($\sim$1000 °C). The standard deviation increases quadratically versus the average temperature and largely reflects the same phenomena as the UL does. There is a correlation between the UL and the temperature standard deviation: once the substrate temperature standard deviation goes beyond -1.6 °C, the UL starts to drop. The explanation is that if taking substrate temperature line profile as a Laplace-Gauss distribution, $3\sigma$ covers 99.7% of the data points. To match acceptable substrate temperature uniformity, $3\sigma$ should be equal to or less than 5 °C ($3\sigma \leq 5$ °C), which gives the result of $\sigma \leq 1.67$ °C.

In summary, the T-shape susceptor is a candidate for high temperature MOVPE processes but can suffer severe temperature non-uniformity issues. In this study, it is found that the modifications of the susceptor geometric can significantly impact the temperature profile and improve uniformity. Specifically, the radius increase of the susceptor and the formation of the hollow structure of the susceptor bottom cylinder can greatly improve temperature uniformity through manipulating the thermal transfer, while the length increase of the susceptor bottom cylinder can only shift the temperature profile. The geometric modification also causes change in the induction heating efficiency. With the proposed techniques, the T-shape susceptor can exhibit excellent temperature uniformity with temperature variation less than 5 °C at -1900 °C and high induction heating efficiency.

**Claims**

1. A susceptor for chemical vapor deposition, comprising:

   a horizontal component with a top surface and a bottom surface, wherein the top surface is configured to support one or more wafers;
   a vertical component extending from the bottom surface of the horizontal component along a longitudinal axis that is substantially perpendicular to the horizontal component; and
   a hollow region within the vertical component.

2. The susceptor according to claim 1, wherein the top surface of the horizontal component plate has a substantially uniform temperature distribution in a radial direction.

3. The susceptor according to claim 1 or 2, wherein a temperature difference across the top surface of the horizontal component in the radial direction is less than or equal to about 3 percent.

4. The susceptor according to anyone of claims 1 to 3, where a temperature difference across the top surface of the horizontal component in the radial direction is less than about 5 °C.

5. The susceptor according to anyone of the preceding claims, wherein the horizontal component is a cylindrical symmetrical disk shape and the vertical component is a cylindrical symmetrical disk shape.

6. The susceptor of claim 5, wherein the radius of the horizontal component is greater than the radius of the vertical component.

7. The susceptor of claim 5 or 6, wherein the radius of the horizontal component is about equal to the radius of the vertical component.

8. The susceptor according to anyone of the preceding claims, wherein the horizontal component and the vertical component are made of the same material.

9. The susceptor according to anyone of the preceding claims, wherein the horizontal component and the vertical component are made of different materials.

10. The susceptor according to anyone of the preceding claims, wherein the horizontal component and the vertical component form a single continuous structure.

11. The susceptor according to anyone of the preceding claims, wherein the hollow region reduces heat transfer to the center of the top surface of the horizontal plate.

12. The susceptor according to anyone of the preceding claims, wherein the hollow region is a cylindrical shape.

13. The susceptor according to anyone of the preceding claims, wherein the hollow region includes fillets on the corners.

14. The susceptor according to anyone of the preceding claims, wherein the horizontal component includes a groove structure for blocking heat transfer to an edge of the horizontal component.

15. The susceptor according to anyone of the preceding claims, wherein a thickness of a wall of the vertical component is about greater than a skin depth.

FIG. 1

**FIG. 2**

Wafer
240

Induction Coil
230

Horizontal plate
201

Vertical rod
204

Thermal Insulator
220

Mushroom type
Susceptor
210

EP 3 597 790 A1

*FIG. 3*

*FIG. 4*

FIG. 5

**FIG. 6**

FIG. 7

## Temperature profile with different L1

FIG. 8

EP 3 597 790 A1

**Temperature profile with different L3**

Increase L3

Increase L3

Temperature (A.U.)

Center of susceptor

Arc length

Edge of susceptor

*FIG. 9*

EP 3 597 790 A1

**FIG. 10A**

**FIG. 10B**

**FIG. 10C**

*FIG. 11*

EP 3 597 790 A1

**FIG. 12**

EP 3 597 790 A1

**FIG. 13**

EP 3 597 790 A1

FIG. 14

**FIG. 15**

EP 3 597 790 A1

**FIG. 16**

FIG. 17

**FIG. 18A**

**FIG. 18B**

**FIG. 18C**

**FIG. 18D**

**FIG. 19A**

**FIG. 19B**

EP 3 597 790 A1

**FIG. 20A**

**FIG. 20B**

**FIG. 21A**

**FIG. 21B**

H —5 mm··· 10 mm---12.5 mm--·15 mm—20 mm

EP 3 597 790 A1

**FIG. 22**

**FIG. 23A**

**FIG. 23B**

EP 3 597 790 A1

FIG. 24B

FIG. 24A

**FIG. 25A**

**FIG. 25B**

EP 3 597 790 A1

**FIG. 26A**

**FIG. 26B**

H——25 mm ······27.5 mm ---30 mm – · 35 mm

EP 3 597 790 A1

**FIG. 27A**

**FIG. 27B**

**FIG. 28A**

**FIG. 28B**

EP 3 597 790 A1

**FIG. 29A**

**FIG. 29B**

**FIG. 30A**

**FIG. 30B**

—45 mm ·····50 mm ---55 mm

EP 3 597 790 A1

FIG. 31B

Temperature (°C)

8" substrate (cm)

—Z = 1 ·····Z = 3 ---Z = 5 -·-Z = 6 —Z = 7

FIG. 31A

*FIG. 32A*

*FIG. 32B*

**FIG. 33A**

**FIG. 33B**

EP 3 597 790 A1

**FIG. 34A**

—60 mm ⋯⋯65 mm ---70 mm

- ⋅75 mm —80 mm

**FIG. 34B**

EP 3 597 790 A1

**FIGURE 35A-B**

**FIGURE 36 A-B**

**FIGURE 37A-B**

**FIGURE 38**

FIGURE 39A-D

FIGURE 40A-F

(a) ——Reference ———Design 1 ———Design 2 ———Design 3 (b) ═══Reference ═══Design 1 ═══Design 2 ═══Design3

**FIGURE 41A-B**

Europäisches
Patentamt

European
Patent Office

Office européen
des brevets

# EUROPEAN SEARCH REPORT

Application Number

EP 19 18 7450

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/021707 A1 (IBRANI SOKOL [US]) 21 January 2016 (2016-01-21) * abstract; claims 1,2; figure 1 * ----- | 1-15 | INV. C23C16/458 C23C16/46 C30B25/12 H05B6/10 |
| X | DE 196 22 402 C1 (SIEMENS AG [DE]) 16 October 1997 (1997-10-16) * abstract; figures 3,4 * ----- | 1 | |
| A | US 2003/209326 A1 (LEE YOUNG JAI [US] ET AL) 13 November 2003 (2003-11-13) * abstract; figures 1-7 * ----- | 1 | |
| A | WO 2010/108744 A1 (FRENI BREMBO SPA [IT]; RINALDI STEFANO [IT]; MAURI BERNARDINO [IT]) 30 September 2010 (2010-09-30) * abstract; figures 1-7 * ----- | 1 | |

TECHNICAL FIELDS
SEARCHED      (IPC)

C23C
C30B
H05B

The present search report has been drawn up for all claims

| Place of search | Date of completion of the search | Examiner |
|---|---|---|
| Munich | 17 October 2019 | Garcia, Jesus |

CATEGORY OF CITED DOCUMENTS

X : particularly relevant if taken alone
Y : particularly relevant if combined with another
   document of the same category
A : technological background
O : non-written disclosure
P : intermediate document

T : theory or principle underlying the invention
E : earlier patent document, but published on, or
   after the filing date
D : document cited in the application
L : document cited for other reasons

 

& : member of the same patent family, corresponding
   document

EPO FORM 1503 03.82 (P04C01)

## ANNEX TO THE EUROPEAN SEARCH REPORT
## ON EUROPEAN PATENT APPLICATION NO.

EP 19 18 7450

This annex lists the patent family members relating to the patent documents cited in the above-mentioned European search report.
The members are as contained in the European Patent Office EDP file on
The European Patent Office is in no way liable for these particulars which are merely given for the purpose of information.

17-10-2019

| Patent document cited in search report | | Publication date | Patent family member(s) | | Publication date |
|---|---|---|---|---|---|
| US 2016021707 | A1 | 21-01-2016 | KR | 20160010342 A | 27-01-2016 |
| | | | TW | 201611156 A | 16-03-2016 |
| | | | US | 2016021707 A1 | 21-01-2016 |
| DE 19622402 | C1 | 16-10-1997 | CN | 1170775 A | 21-01-1998 |
| | | | DE | 19622402 C1 | 16-10-1997 |
| | | | EP | 0811703 A2 | 10-12-1997 |
| | | | JP | H1072281 A | 17-03-1998 |
| | | | US | 6153012 A | 28-11-2000 |
| US 2003209326 | A1 | 13-11-2003 | AU | 2003221961 A1 | 11-11-2003 |
| | | | CN | 1653591 A | 10-08-2005 |
| | | | DE | 10392595 T5 | 16-06-2005 |
| | | | JP | 4786177 B2 | 05-10-2011 |
| | | | JP | 2005530335 A | 06-10-2005 |
| | | | KR | 20040107477 A | 20-12-2004 |
| | | | TW | I278935 B | 11-04-2007 |
| | | | US | 2003209326 A1 | 13-11-2003 |
| | | | US | 2006032848 A1 | 16-02-2006 |
| | | | WO | 03096396 A1 | 20-11-2003 |
| WO 2010108744 | A1 | 30-09-2010 | EP | 2411751 A1 | 01-02-2012 |
| | | | IT | 1394098 B1 | 25-05-2012 |
| | | | JP | 2012521531 A | 13-09-2012 |
| | | | SI | 2411751 T1 | 28-06-2013 |
| | | | US | 2012085752 A1 | 12-04-2012 |
| | | | WO | 2010108744 A1 | 30-09-2010 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 62396679 A